(19) Europäisches Patentamt
European Patent Office
Office européen des brevets

(11) EP 4 163 976 A1

(12) EUROPEAN PATENT APPLICATION

(43) Date of publication:
**12.04.2023 Bulletin 2023/15**

(21) Application number: **22160965.4**

(22) Date of filing: **09.03.2022**

(51) International Patent Classification (IPC):
***H01L 27/1157*** *(2017.01)* ***H01L 27/11582*** *(2017.01)*
***G11C 11/00*** *(2006.01)*

(52) Cooperative Patent Classification (CPC):
**G11C 11/005; G11C 11/5621; G11C 16/08; H10B 43/27; H10B 43/35;** G11C 11/5642

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.10.2021 US 202163253000 P**
**18.01.2022 US 202217578057**

(71) Applicant: **MACRONIX INTERNATIONAL CO., LTD.**
**Hsinchu (TW)**

(72) Inventors:
- **Shen, Kuan-Yuan**
**Zhubei City (TW)**
- **Chiu, Chia-Jung**
**Zhubei City (TW)**

(74) Representative: **Becker, Eberhard**
**Becker Kurig & Partner**
**Patentanwälte mbB**
**Bavariastraße 7**
**80336 München (DE)**

# (54) SEMICONDUCTOR MEMORY DEVICE, INTEGRATED CIRCUIT CHIP AND METHOD OF MANUFACTURING VERTICAL MEMORY STRUCTURE

(57) An embodiment of the present disclosure provides a semiconductor memory device, an integrated circuit chip and a method of manufacturing vertical memory structure. The memory device comprises a substrate. A plurality of word line layers are disposed over the substrate. An array of vertical NOR columns is in a first area of the plurality of word line layers. Each vertical NOR column includes a first conductive pillar and a second conductive pillar. Each vertical NOR column comprises a first plurality of memory cells arranged in a NOR configuration formed at cross points of word line layers in the plurality of word line layers with the first and second conductive pillars. An array of vertical NAND columns is in a second area of the plurality of word line layers. Each vertical NAND column includes a memory pillar. Each vertical NAND column comprises a second plurality of memory cells arranged in a NAND configuration formed at cross points of word line layers with the memory pillar.

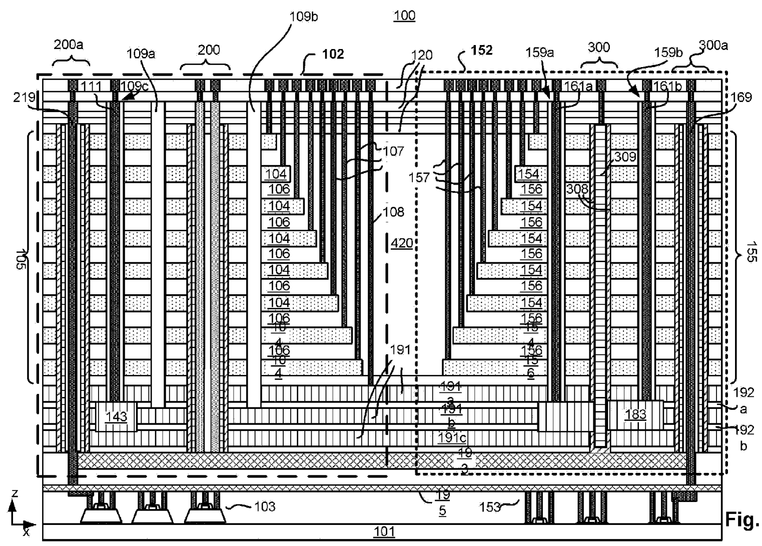

Fig. 1



Processed by Luminess, 75001 PARIS (FR)

## Description

### BACKGROUND

#### Field

The present invention relates to three-dimensional (3D) memory devices, and integration of 3D NOR and 3D NAND memory devices.

#### Description of Related Art

As critical dimensions of devices in integrated circuits shrink to the limits of common memory cell technologies, designers have been looking to techniques for stacking multiple planes of memory cells to achieve greater storage capacity, and to achieve lower costs per bit. In recent years, three-dimensionally stacked memory have been developed, which includes vertically stacked memory cells. Examples of such three-dimensionally stacked memory include three-dimensionally stacked NAND flash memory and three-dimensionally stacked NOR memory.

In general, NOR memory allows relatively fast read, random-access times, reliable code storage, and ease-of-use (e.g., compared to NAND memory). In an example, NOR memory may be suitable for execute-in-place applications, BIOS, and firmware applications. On the other hand, NAND memory generally features relatively faster write operations (e.g., write by page) and erase operations (e.g., erase by block), relatively low cost-per-bit and relatively higher density (e.g., compared to NOR memory). In an example, NAND memory may be suitable for data storage applications. Thus, devices may use NOR memory for relatively fast boot and random-access coding, and may use NAND memory for high-density and high-capacity data storage.

It is desirable to provide technology for a three-dimensionally stacked integrated circuit memory having advantages of both NAND and NOR memory. For example, it is desirable to provide technology for co-integration of 3D NOR and 3D NAND memory in a same integrated circuit memory chip.

### SUMMARY

An embodiment of the present disclosure provides a memory device. The memory device comprises a substrate. A plurality of word line layers are over the substrate. An array of vertical NOR columns is in a first area of the plurality of word line layers. Each vertical NOR column in the array of vertical NOR columns includes a first conductive pillar and a second conductive pillar. Each vertical NOR column comprises a first plurality of memory cells arranged in a NOR configuration formed at cross points of word line layers in the plurality of word line layers with the first and second conductive pillars. An array of vertical NAND columns is in a second area of the plurality of word line layers. Each vertical NAND column in the array of vertical NAND columns includes a memory pillar. Each vertical NAND column comprises a second plurality of memory cells arranged in a NAND configuration formed at cross points of word line layers in the plurality of word line layers with the memory pillar.

An embodiment of the present disclosure includes an Integrated Circuit (IC) chip. The Integrated Circuit (IC) chip includes a substrate. A three-dimensional (3D) NOR having a first word line is disposed over the substrate. A 3D NAND having a second word line is disposed over the substrate. The first word line layer and the second word line layer are part of a same patterned layer. In another example, the first word line layer and the second word line layer are disposed a same horizontal plane.

An embodiment of the present disclosure includes a method of manufacturing a vertical memory structure. The method includes alternating insulating layers and sacrificial layers are formed covering an area on a substrate. The alternating insulating layers and sacrificial layers covering the area are partitioned. A first stack of alternating insulating layers and sacrificial layers and a second stack of alternating insulating layers and sacrificial layers are formed. A vertical NOR memory array within the first stack and a vertical NAND memory array within the second stack are formed. The sacrificial layers of the first stack and the second stack are replaced with word line material. Many process steps applied to the first and second stacks can be shared in technologies described herein, for efficient manufacturing of a complex memory device.

Other aspects and advantages of the present invention can be seen on review of the drawings, the detailed description and the claims, which follow.

### BRIEF DESCRIPTION OF THE DRAWINGS

Fig. 1 is a semiconductor memory device comprising two vertical memory structures formed on a same substrate.

Fig. 2A is a zoomed-in view of a NOR memory of the semiconductor memory device of Fig. 1.

Figs. 2B and 2C illustrates a memory channel of the NOR memory of Fig. 2A.

Fig. 2C1 illustrates operation of a NOR memory cell of Figs. 1, 2A, and 2B.

Fig. 2D is a schematic circuit diagram of a NOR array of memory cells implemented as illustrated in Figs. 1 and 2A-2C.

Figs. 2E and 2F illustrate in further detail a section of the NOR memory of Fig. 1, where the section includes a through-hole interconnect to access logic circuit underneath the NOR memory.

Figs. 2E1 and 2F1 illustrate an alternative configuration of the section of Figs. 2E and 2F.

Fig. 2G illustrates a first vertical opening, a second vertical opening, and a third vertical opening extending through a stack of alternating word line layers and insulating layers of a NOR memory of Fig. 1.

Fig. 3A is a zoomed-in view of a NAND memory of the semiconductor memory device of Fig. 1.

Fig. 3B is a cross-section of a memory cell formed in the NAND memory of Fig. 3A.

Fig. 3C is a schematic circuit diagram of a NAND array of memory cells implemented as illustrated in Figs. 1, 3A, and 3B.

Fig. 3D illustrates operation of a NAND memory cell of Figs. 1, 3A, 3B, and 3C.

Figs. 4A, 4B1, 4B2, 4C, 4D, 4E, 4F, 4G, 4H, 41, 4J, 4J1, 4K, 4L, 4M, and 4N illustrate stages in a manufacturing process usable to manufacture the semiconductor memory device 100 of Figs. 1-3D.

Fig. 5 illustrates the semiconductor memory device of Fig. 1, where a first section of conductive layers underneath a NOR memory and a second section of the conductive layers underneath a NAND memory are physically separated.

Fig. 6A illustrates an example in which the semiconductor memory device of Fig. 1 is used for "compute in memory" (CIM) applications.

Fig. 6B illustrates an example system that includes the semiconductor memory device of Figs. 1-6A, in which the semiconductor memory device is used for CIM applications.

Figs. 7 illustrates a system that includes the semiconductor memory device of Figs. 1-6B, where a host communicates with the semiconductor memory device directly (e.g., by bypassing a Random Access Memory (RAM)), and where the semiconductor memory device can implement "execute in place" (XIP) functions.

## DETAILED DESCRIPTION

A detailed description of embodiments of the present invention is provided with reference to the following figures.

Fig. 1 illustrates a semiconductor memory device 100 comprising two vertical memory structures 102 and 152 having different access architectures (e.g., NOR and NAND) formed on a same substrate 101. Each of the vertical memory structures 102 and 152 comprises a corresponding plurality of memory cells. For example, the memory cells of the vertical memory structure 102 are arranged in a NOR configuration, and hence, the vertical memory structure 102 is also referred to as a 3D NOR memory structure 102, or simply as NOR memory structure 102. In an example, the memory cells of the vertical memory structure 152 are arranged in a NAND configuration, and hence, the vertical memory structure 152 is also referred to as a 3D NAND memory structure 152, or simply as NAND memory structure 152. In an example, the semiconductor memory device 100 is a memory chip, such as an Integrated Circuit (IC) memory chip.

As discussed, the NOR memory structure 102 comprises a stack 105 of alternating insulating layers 106 and word line layers 104 over the substrate 101. In an example, the word line layers 104 comprise conductive material, such as tungsten or other appropriate conductive material that may be used for word lines of 3D memory array. The NAND memory structure 152 comprises a stack 155 of alternating insulating layers 156 and word line layers 154. The word line layers 154 is the NAND memory structure 152 can be parts of the same patterned layers of word line material as the word line layers 104 in the NOR memory structure.

Logic circuit 103 comprising a plurality of active devices, such as transistors, are disposed underneath the NOR memory structure 102, e.g., between the NOR memory structure 102 and the substrate 101.

Logic circuit 153 comprising a plurality of active devices, such as transistors, are disposed underneath the NAND memory structure 152, e.g., between the NAND memory structure 152 and the substrate 101.

The logic circuit 103 and logic circuit 153, in one example, comprise CMOS (complementary metal-oxide-semiconductor) circuits that may be used to control one or more operations of the NOR memory structure 102 and the NAND memory structure 152. Thus, Fig. 1 is an example of "CMOS under array" (CUA) architecture, where the logic circuit 103 comprising the CMOS control circuits are disposed underneath the memory array of the NOR memory structure 102. The principles of this disclosure, however, are not limited to such a specific architecture. For example, the principles of this disclosure may also be used to form a memory device that cointegrates 3D NOR memory and 3D NAND memory, where the 3D NOR and/or the 3D NAND employs "CMOS near array" (CNA) architecture, where the CMOS logic circuits are disposed on a side of the memory array.

Fig. 2A is a zoomed-in view of the NOR memory structure 102, illustrating various details of the NOR memory structure 102. A section 200 of the NOR memory structure 102, which includes a channel layer 209, is illustrated in further detail in Figs. 2B and 2C. Fig. 2C is a cross-section taken at line A-A of Fig. 2B. The right side of the illustration in Fig. 2A is disposed between the NOR and NAND memory structures on a single integrated circuit as illustrated in Figure 1. In the embodiment illustrated in Fig. 2A, the right side of the stairstep structure for the NOR memory structure is continuous with the left side of the stairstep structure for the NAND memory structure illustrates in Figure 3A.

Referring to Figs. 1, 2A, 2B, and 2C, the stack 105 of alternating insulating layers 106 and word line layers 104 includes a vertical opening in section 200. The vertical opening in the section 200 extends through the stack 105 of alternating insulating layers 106 and word line layers 104. A sidewall surface of the vertical opening in the section 200 is composed of the stack 105 of alternating insulating layers 106 and word line layers 104. The vertical opening of the section 200 can have a circular horizontal cross-section as illustrated in the example of Fig. 2C. In other embodiments, the vertical opening can have horizontal cross section that is elliptical or other shapes. Referring now to Figs. 2B and 2C, structures disposed in the vertical opening in section 200 include a first conductive pillar 204 inside and on a first side of the vertical opening of the section 200, and a second conductive pillar 205 inside and on a second side of the vertical opening of the section 200. The first and second conductive pillars 204, 205 extend from a top of the vertical opening of the section 200 to a bottom of the vertical opening of the section 200, and are separated from each other by an insulating filling layer 211.

As illustrated in Figs. 2B and 2C, structures disposed in the vertical opening in section 200 include a data storage structure 208, such as a dielectric charge storage structure implemented using so-called SONOS, BE-SONOS and related technologies. The data storage structure 208 of the NOR memory structure 102 extends in the Z-direction within the vertical opening of the section 200. The data storage structure 208 of the NOR memory structure 102 can include a multilayer dielectric having a tunneling layer, a charge trapping layer, and a blocking layer. The tunneling layer can comprise a silicon oxide, or a silicon oxide/silicon nitride combination (e.g., Oxide/Nitride/Oxide or ONO). The charge trapping layer can comprise silicon nitride or other materials capable of trapping charges. The blocking layer can comprise silicon oxide, aluminum oxide, and/or combinations of such materials. The data storage structure 208 (the tunneling layer/the charge trapping layer/the blocking layer), as discussed above, may have any different combination of materials. In some examples, the data storage structure 208 is implemented using floating gate having polysilicon charge trapping layer. The data storage structure 208 in the section 200 of the NOR memory structure 102 stores charges of individual NOR memory cells. Referring to Figs. 2B and 2C, a memory cell 220 of the NOR memory structure 102 is described. The memory cell 220 is disposed at an intersection (cross-point) of the vertical opening in the section 200 and the word line layer 104. Fig. 2C shows the memory cell 220 in a cross-section taken at line A-A of Fig. 2B. The memory cell 220 includes the word line layer 104 surrounding the data storage structure 208, a channel layer 209, the first conductive pillar 204, and the second conductive pillar 205. An insulating filling layer 211 is filled in a gap surrounded by the channel layer 209 and not occupied by the first conductive pillar 204, the second conductive pillar 205.

As illustrated in Figs. 2B and 2C, the channel layer 209 is disposed on an internal surface of the data storage structure 208 around the perimeter of the vertical opening in section 200. The channel layer 209 is between the data storage structure 208 and the first conductive pillar 204. Also, the channel layer 209 is between the data storage structure 208 and the second conductive pillar 205. The channel layer 209 is between the insulating filling layer 211 and the data storage structure 208 in regions around the perimeter of the opening between the first and second conductive pillars 204, 205. In an example, the channel layer 209 is present at least at the levels of the word line layers 104. The channel layer 209 comprises a semiconductor layer such as polysilicon, germanium or silicon/germanium, used for charge transport during operation of the memory cells.

As seen in Figs. 2B and 2C, the word line layers 104 constitute word lines of the NOR memory structure 102. The channel layer 209 is disposed on the internal surface of the data storage structure 208 extending along the z-direction of the vertical opening of the section 200. The channel layer 209 has a contact S/D 221a with the first conductive pillar 204 on a first side of the vertical opening in section 200, and a contact S/D 221b with the second conductive pillar 205 on a second side of vertical opening in section 200. As shown in Fig. 2C, the first conductive pillar 204 and the second conductive pillar 205 act as source/drain terminals of the memory cell 220.

As shown in Fig. 2C, channel regions are within the channel layer 209 of memory cell 220 of the NOR memory structure 102. The channel regions extend around the perimeter of the vertical opening in section 200. Arrows 203 indicate the current flow path within the channel regions between the source/drain terminals (the first conductive pillar 204/the second conductive pillar 205) at the contacts S/D 221a and S/D 221b. Thus, the memory cell 220 has a horizontal channel, perpendicular to a direction of the conductive pillars 204, 205. Memory cells are disposed in a column along the z-direction of the vertical opening of the section 200 in a NOR configuration. The memory cells in the same vertical opening of section 200 are electrically connected in parallel between the first conductive pillar 204 and the second conductive pillar 205.

The memory cells of the NOR memory structure 102 can be a dielectric charge trapping memory cell, in which charges are trapped in the data storage structure 208 at the memory cell 220, representing data, over the channel layer 209 between the source and drain terminals (the first conductive pillar 204/the second conductive pillar 205). The gate of the memory cell is formed by the word line layer 104 of the corresponding word line.

Fig. 2C1 illustrates operation of a NOR memory cell. For example, three consecutive NOR memory cells 220a, 220b, 220c are illustrated and labelled in Fig. 2C1, where the three consecutive NOR memory cells 220a, 220b, 220c are coupled in parallel between the conductive pillars 204, 205 (e.g., which act as the source and drain terminals, respectively, for the memory cells). Assume that the memory cell 220b is to be read during a read operation. The channel region of the channel layer 209 of the NOR memory is horizontal, as discussed with respect to Fig. 2C. A read voltage is applied to the word line layer 104 of the selected memory cell 220b, and the channel regions of the non-selected memory cells 220a, 220c are turned off. Depending on a data stored in the memory cell 220b, current may pass from the conductive pillar 205, via the channel region of the memory cell 220b, to the conductive pillar 204 (path of current illustrated using the thick arrows in the figure), which may then be sensed during the read operation.

Referring to Fig. 1, a plurality of dielectric layers 120 are disposed over the stack 105 of alternating insulating layers 106 and word line layers 104. At least upper sections of the conductive pillars 204, 205 extend through at least some of the dielectric layers 120. Contact plugs 215 and 216 (see Fig. 2B) can be formed through the dielectric layers 120 for connection to the conductive pillars 204 and 205, respectively. The overlying patterned conductors are used for global bit lines, source lines, word lines and other circuits supporting operation of the memory.

As illustrated schematically in Fig. 2D, a plurality of bit lines (e.g., BLn and BL(n+1)) are disposed over and connected to respective contact plugs 216. The plurality of bit lines extends in a second direction (Y-direction) orthogonal to a plurality of word line (e.g., WL(i)m and WL(i)(m+1)) in a first X-direction illustrated in Fig 2D. The first X-direction is also perpendicular to the Z-direction in which the conductive pillars 204, 205 extend.

A plurality of source lines are disposed over and connected to respective contact plugs 215. The plurality of source lines extend in the second direction (Y-direction) orthogonal to the plurality of word line (e.g. WL(i)m and WL(i)(m+1)) in the first direction (X-direction).

Fig. 2D is a schematic circuit diagram of a NOR array of memory cells implemented as illustrated in Figs. 1 and 2A-2C. The conductive pillars 204, 205 are coupled to respective ones of the source line SLn and bit line BLn, source line SL(n+1) and bit line BL(n+1). At each layer, an individual word line WL (e.g., word line layer 104) is disposed, and penetrated by the plurality of conductive pillars (204, 205). Memory cells are disposed at the cross-points of the word lines and the conductive pillars (204, 205), and arranged in a NOR configuration.

For example, a stack of word lines WL(i)m and WL(i)(m+1) are interleaved with alternating insulating layers (not illustrated). A first memory cell is formed at a cross point of word line WL(i)m, and source line SLn and bit line BLn. A second memory cell is formed at a cross point of word line WL(i)(m+1), and source line SLn and bit line BLn. The first and second memory cells are coupled in parallel.

Similarly, a third memory cell is formed at a cross point of word line WL(i)m, and source line SL(n+1) and bit line BL(n+1). A fourth memory cell is formed at a cross point of word line WL(i)(m+1), and source line SL(n+1) and bit line BL(n+1). The third and fourth memory cells are coupled in parallel. Similarly, four memory cells are formed at cross points of WL(i+1)m and WL(i+1)(m+1), and respective source and bit lines, as illustrated in Fig. 2D.

Referring again to Figs. 1 and 2A, the NOR memory structure 102 also includes a section 200a that includes a through-hole interconnect 219, e.g., to access the logic circuits 103 from top of the NOR memory structure 102. Figs. 2E and 2F illustrate further details of the section 200a of the NOR memory of Fig. 1, where the section 200a includes the through-hole interconnect 219 to access the logic circuit 103 underneath the NOR memory structure 102. Figs. 2E1 and 2F1 illustrate an alternative configuration of the section 200a of Figs. 2E and 2F. Fig. 2F is a cross-section taken at line B-B of Fig. 2E. Fig. 2F1 is a cross-section taken at line B-B of Fig. 2E1.

In an embodiment, the section 200a includes a through-hole, which is a vertical opening extending through the stack 105 of alternating insulating layers 106 and word line layers 104. A via comprising conductive material (such as tungsten, copper, aluminum, gold, silver, or another appropriate metal or metal alloy, or a non-metal conductive material such as polysilicon) forms the through-hole interconnect 219 within the through-hole of the section 200a.

In the example of Figs. 2E and 2F, the through-hole interconnect 219 of the section 200a is surrounded by data storage structure 208, channel layer 209, and layer 223 of insulating material that separates the through-hole interconnect 219 from the channel layer 209. The configuration of the data storage structure 208 and the channel layer 209 have been discussed in further detail with respect to Figs. 2B and 2C. Note that no memory cells are formed on the cross point of the layers 104 of word lines and the through-hole interconnect 219. For example, the through-hole interconnect 219 is isolated from the channel layer 209 by the layer 223 of insulating material. In an example, the through-hole interconnect 219 is used to access the logic circuits 103 disposed underneath the NOR memory structure 102. As illustrated, the through-hole interconnect 219 is coupled to the logic circuit 103 via one or more metallization layers, such as metallization layer 195.

In the example of Figs. 2E1 and 2F1, the through-hole interconnect 219 of the section 200a is surrounded by layer 223 of insulating material disposed in the vertical opening of the section 200a. Thus, unlike Figs. 2E and 2F, in the example of Figs. 2E1 and 2F1, no data storage structure 208 or channel layer 209 are disposed within the vertical opening of the section 200a. Put differently, while the vertical opening of the section 200a in Figs. 2E and 2F included the data storage structure 208 or channel layer 209 extending in the Z-direction, these layers are absent in the vertical opening of the section 200a in Figs. 2E1 and 2F1.

Fig. 2G illustrates a portion of the NOR memory structure 102 of Figs. 1 and 2A, and further illustrates a first vertical opening 109a, a second vertical opening 109b, and a third vertical opening 109c extending through the stack 105 of alternating word line layers 104 and insulating layers 106 of the NOR memory structure 102 of Fig. 1. Note that these vertical openings are also illustrated in Figs. 1 and 2A, but Fig. 2G illustrates these vertical openings in further detail.

As illustrated in Figs. 1, 2A, and 2G, underneath the stack 105 of alternating insulating layers 106 and word line layers 104 are conductive layers 191a, 191b, 191c, which are also collectively referred to as conductive layers 191. Each of these conductive layers 191a, 191b, 191c extends in a corresponding horizontal plane parallel to the substrate 101, as illustrated in Fig. 2G. In an example, the conductive layers 191 comprise conductive material, such as polysilicon, tungsten, or an appropriate metal or metal alloy. Although three such conductive layers 191a, 191b, 191c are illustrated, there may be a different number of such conductive layers, such as one, two, four, five, or higher.

It may be noted that the conductive layers 191 are present at a bottom portion of the NOR memory structure 102 and the NAND memory structure 152. As will be discussed herein later and although not illustrated in Fig. 1, a first section of the conductive layer 191a at the bottom portion of the NOR memory structure 102 can be electrically isolated from a second section of the conductive layer 191a at the bottom portion of the NAND memory structure 152; a first section of the conductive layer 191b at the bottom portion of the NOR memory structure 102 can be electrically isolated from a second section of the conductive layer 191b at the bottom portion of the NAND memory structure 152, and so on. Such isolation can be achieved by, in one example, patterning the conductive layers 191 in the first and second sections, i.e., physically isolating the two sections (e.g., illustrated in Fig. 5, discussed herein later) in an area between the NOR memory structure 102 and the NAND memory structure 152. Such isolation can also be achieved by, in another example, ion implantation in a middle section (e.g., an area between the NOR memory structure 102 and the NAND memory structure 152) of the conductive layers 191 that is between the first and second sections (e.g., illustrated as region 407 in Fig. 4B1, discussed herein later).

Referring again to Fig. 2G, in an example, the conductive layers 191a, 191b, 191c are separated by dielectric layers 192a and 192b. For example, dielectric layer 192a is between the conductive layers 191a and 191b, and dielectric layer 192b is between the conductive layers 191b and 191c. The dielectric layers 192a, 192b can comprise materials such as silicon oxides and silicon nitrides.

In an example, the vertical openings 109a and 109b of the NOR memory structure 102 (see Fig. 2G) extend through the stack 105 of alternating word line layers 104 and insulating layers 106 of the NOR memory structure 102, and also extend through one or more of the conductive layers 191a, 191b, and 191c. In the example of Fig. 2G, the vertical openings 109a and 109b extend through the stack 105 of alternating word line layers 104 and insulating layers 106 of the NOR memory structure 102, and also extend through the conductive layer 191a and dielectric layer 192a, and end on the conductive layer 191b. As will be discussed herein later, the vertical openings 109a and 109b are used for removal of sacrificial material prior to deposition of word line material, and may not be used for any electrical operation of the NOR memory structure 102. Accordingly, in an example, the vertical openings 109a and 109b can be filled with electrically floating conductive material, dielectric material, or can remain unfilled (e.g., void filled with air).

Still referring to Figure 2G, in an embodiment, the vertical opening 109c includes a dummy gate contact 111 extending vertically through the vertical opening 109c. The dummy gate contact 111 electrically connects to a dummy cell 144 at the bottom of section 200, as discussed later. The dummy gate contact 111 comprises conductive material, such as tungsten, copper, aluminum, gold, silver, or another appropriate metal or metal alloy, or a non-metal conductive material such as polysilicon. The dummy gate contact 111 is separated from the sidewalls of the vertical opening 109c by insulating material 229, which can be, for example, an appropriate oxide, such as silicon oxide. In the example of Fig. 2G, the dummy gate contact 111 is coupled to the top metallization layers through interconnect structures 235 (which may include a metal plug).

As illustrated in Fig. 2G, a conductive structure 143 (which can be same as the material of the conductive layers 191) electrically interconnects the conductive layers 191a, 191b, and 191c. Thus, the conductive layers 191a, 191b, 191c adjacent to the section 200 at the bottom portion of the NOR memory structure 102 are electrically coupled to each other, through the conductive structure 143.

As illustrated using dashed line in Fig. 2G, a dummy cell 144 is formed at an overlap area of at least one conductive layer 191 and the channel layer 209. The electrically coupled the at least one conductive layer 191 (e.g. conductive layers 191a, 191b, 191c) adjacent to this dummy cell 144 act as a gate of this dummy cell 144. By applying a voltage through dummy gate contact 111 to the gate of this dummy cell 144, a channel region of this dummy cell 144 is electrically switched off. In an embodiment, the dummy cell 144 is used to prevent or reduce leakage current in the portion of the section 200 of the NOR memory structure 102 that is buried in the conductive layers 191, i.e., prevent or reduce leakage current in the lower portion of the section 200.

Referring again to Figs. 1 and 2A, the word line layers 104 within the NOR memory structure are arranged in a stepped or staircase configuration, such that word line contacts 107 can access individual word line layers 104. A stair step contact area is between the stack 105 and the stack 155. For example, deep etches are made through the NOR memory structure 102 in order to form the word line contacts 107, to connect the conductive word line layers 104 to metal interconnects above the NOR memory structure 102.

Also illustrated in Figs. 1 and 2A is a contact 108 that connects to the conductive layer 191a. As discussed with respect to Fig. 2G, the dummy gate contact 111 within the vertical opening 109c forms a contact to the conductive layers 191. In an example, the contact 108 can also act as a dummy gate contact instead of, or in addition to, the dummy gate contact 111 within the vertical opening 109c. In an example where the contact 108 is present in the NOR memory structure 102, the dummy gate contact 111 within the vertical opening 109c and/or the interconnect structures 235 (see Fig. 2G) can be absent or can be electrically floating, and the vertical opening 109c can be filled with electrically floating conductive material or insulating material. In another example where the dummy gate contact 111 is present within the vertical opening 109c, the contact 108 of Fig. 2A can be absent from the NOR memory structure 102. Thus, at least one, or both, of the dummy gate contact 111 within the vertical opening 109c and the contact 108 is present in the NOR memory structure 102, and act(s) as a dummy gate contact for the dummy cell 144 (see Fig. 2G).

Fig. 3A is a zoomed-in view of the NAND memory structure 152 of the semiconductor memory device 100 of Fig. 1. A section 300 of the NAND memory structure 152, which includes a channel layer 309, is illustrated in further detail in Fig. 3B. Fig. 3B is a cross-section of a memory cell 320 (see Fig. 3A) taken in the horizontal direction through a word line layer 154.

The section 300 is a memory pillar extending in the Z-direction through the stack 155 of alternating word line layers 154 and the insulating layers 156. The vertical opening in the section 300 of the NAND memory structure 152 includes a channel layer 309 comprising semiconductor material such as polysilicon. The channel layer 309 extends downward in the Z-direction along of the vertical opening in the section 300. The vertical opening of section 300 is circular in the example of Fig. 3B. In other embodiments, the vertical opening can be elliptical or have other shapes.

A data storage structure 308 within the vertical opening of section 300 of the NAND memory structure 152 may be, for example, a dielectric charge storage structure implemented using so-called SONOS, BE-SONOS and related technologies. The data storage structure 308 extends in the Z-direction on an internal surface of the vertical opening of the section 300. The channel layer 309 is surrounded by the data storage structure 308 along the Z-direction providing a vertical channel for a series of memory cells in the section 300. The data storage structure 308 includes a multilayer dielectric having a tunneling layer, a charge trapping layer, and a blocking layer. The tunneling layer comprises silicon oxide, or silicon oxide/silicon nitride combination (e.g., Oxide/Nitride/Oxide or ONO). The charge trapping layer comprises silicon nitride or other materials capable of trapping charges. The blocking layer comprises silicon oxide, aluminum oxide and/or combinations of such materials. In some examples, the data storage structure 308 of the NAND memory structure 152 is implemented using floating gate having polysilicon charge trapping layer. The data storage structure 308 (the tunneling layer/the charge trapping layer/the blocking layer) as discussed above may have any different combination of materials. The data storage structure 308 of the section 300 stores charge of individual NAND memory cells. As illustrated in the cross section view of Fig. 3B taken horizontally across the section 300 at the level of a word line layer 154, a dielectric core 311 is in the middle of channel layer 309. The dielectric core 311 also extends downward in the Z-direction in the vertical opening of the section 300. A stack of gate all-around word line layers 154 is intersected by the memory pillar of the section 300. A frustum of the memory pillar of the section 300 at each word line layer 154 combines with the gate all-around word line structure at that layer, to form a corresponding memory cell, such as the memory cell 320 illustrated in Fig. 3A. The memory pillar of the section 300 comprises dielectric core 311 (see Fig. 3B), channel layer 309, and data storage structure 308.

Referring again to Figs. 1 and 3A, as discussed with respect to Fig. 2A, a plurality of dielectric layers 120 are disposed over the stack 155 of alternating insulating layers 156 and word line layers 154 of the NAND memory structure 152. At least an upper section of the pillar of the section 300 extends through at least some of the dielectric layers 120. Contact plug 315 can be formed through the dielectric layers 120 for connection to the channel layer 309.

A plurality of bit lines (see Fig. 3C) can be disposed over and connected to a plurality of corresponding bit line select transistors, the bit lines extending in a second direction (Y-direction) orthogonal to the first direction (X-direction) discussed previously. The bit lines can be connected to respective upper ends of the corresponding channel layers 309 via corresponding contact plugs 315.

As illustrated in Fig. 3A, the NAND memory structure 152 comprises a source line (SL) structure 183 underneath the stack 155 of alternating word line layers 154 and insulating layers 156. The source line (SL) structure 183 (which can be same as the material of the conductive layers 191). Similar to the conductive structure 143 discussed with respect to Fig. 2G, the SL structure 183 electrically couples at least one conductive layer 191 (e.g. the conductive layers 191a, 191b, 191c), and extends through the dielectric layers 192a, 192b. The at least one conductive layer 191 (e.g. conductive layers 191a, 191b, 191c) adjacent to the channel layer 309 act as a source line for the NAND memory structure 152.The SL structure 183 makes direct contact for a current flow connection with the channel layer 309 at a bottom portion of the section 300, and the current flow through the at least one conductive layer 191 (e.g. conductive layers 191a, 191b, 191c). That is, the data storage structure 308 is absent (e.g., etched) between the SL structure 183 and the channel layer 309.

Also illustrated in Fig. 3A are vertical openings 159a, 159b. Conductive material are deposited in the vertical openings 159a, 159b, to respectively form interconnects 161a, 161b. The interconnect 161a is separated from the sidewalls of the vertical opening 159a by insulating material (not labelled in Fig. 3A). Similarly, the interconnect 161b is separated from the sidewalls of the vertical opening 159b by insulating material (not labelled in Fig. 3A). In an example, one or both the interconnects 161a and/or 161b act as source line contacts, to couple the SL structure 183 to circuits for the NAND memory structure 152.

Fig. 3C is a schematic circuit diagram of a NAND array of memory cells implemented as illustrated in Figs. 1, 3A, 3B. The vertical memory pillars discussed with respect to section 300 are coupled to respective ones of the bit lines BL1 and BL2. At each word line layer, an individual word line WLi is disposed (where i = 0, ..., 31 in the example of Fig. 3C), and penetrated by the plurality of memory pillars. Memory cells are disposed at the cross-points of the word lines and the memory pillars, and arranged in a NAND series configuration. The memory cells of the same vertical opening of the section 300 (i.e. the same memory pillar) are electrically connected in series.

The word line layers 154 intersect only some of the memory pillars in the overall structure, and the word line layers 154 define a block of memory cells. For example, a memory block 375a comprising example vertical memory pillars 377a and 377b is labelled in Fig. 3C, and another memory block 375b comprising other example vertical memory pillars is also labelled in Fig. 3C.

For example, to read data from a particular block of the memory, control circuitry activates a word line WLi to select a particular layer of the stack, activates a string select line SSL to select a particular block and activates a bit line BLi to activate a cell at the activated layer in the activated block. A lower select gate is activated as well by a GSL lines. A row of cells is then read out in parallel via the bit line conductors into a page buffer (not shown). ("Activate", as used herein, means to apply a particular bias so as to give effect to the connected cells or switches. The bias may be high or low, depending on the memory design.) Depending on the product specification and design, the page buffer may hold two or more rows of data, in which case a full page read operation would involve successive activation of two or more SSLs.

Fig. 3D illustrates operation of a NAND memory cell. For example, three consecutive series connected NAND memory cells 320a, 320b, 320c are illustrated and labelled in Fig. 3D. The vertical channel layer 309 (see section 300 of Figs. 3A and 3B) passes through the memory cells 320a, 320b, 320c. Assume that the memory cell 320b is to be read during a read operation. A read voltage Vread is applied to the selected memory cell 320b, and a pass voltage Vpass is applied to the non-selected memory cells 220a, 220c that are in a pass-through state (i.e., the channel layer of the non-selected memory cells allow flow of current). Depending on a data stored in the selected memory cell 320b, current may pass (or be blocked) through the channel layer of the memory cell 320b, which may then be sensed during the read operation.

Referring again to Figs. 1 and 3A, the NAND memory structure 152 also includes a section 300a that includes a through-hole interconnect 169, e.g., to access the logic circuits 153 below the structure 152 from top of the NAND memory structure 152. The interconnect 169 and the section 300a can have structures that are similar to the through-hole interconnect 219 and the section 200a of Figs. 2E, 2F, 2E1, and 2F1. Thus, in an example, the interconnect 169 can be surrounded by a data storage structure and a channel layer, e.g., as discussed with respect to Figs. 2E and 2F (although such structures and layers are not labelled in Fig. 3A). In another example, the interconnect 169 can be surrounded by insulating material (and not by data storage structure and/or channel layer), e.g., as discussed with respect to Figs. 2E1 and 2F1. The section 300a of Fig. 3A would be apparent to those skilled in the art, based on the discussion of section 200a with respect to Figs. 2E, 2F, 2E1, 2F1.

As illustrated in Figs. 1, 2A and 3A, the word line layers 154 within the NOR memory structure and within NAND memory structure 152 are arranged in a stepped or staircase configuration, such that word line contacts 157 can access individual word line layers 154. For example, deep etches are made through insulating material 420 of the memory structure in order to form the word line contacts 157, to connect the conductive word line layers 154 to metal interconnects above the memory array. The left side of the illustration in Fig. 3A is disposed between the NOR and NAND memory structures on a single integrated circuit as illustrated in Figure 1. In the embodiment illustrated in Figs. 2A and 3A, the right side of the stairstep structure for the NOR memory structure is continuous with the left side of the stairstep structure for the NAND memory structure illustrates in Figure 3A.

The staircases of the NOR memory structure 102 and the NAND memory structure 152 are located in the center of the chip, away from the scribe lines. Also, the staircases of the NOR memory structure 102 and the NAND memory structure 152 can be formed the same process steps and used for NOR and NAND memory cells. As a result, the design can reduce waste of chip area.

The staircases of the NOR memory structure 102 and the NAND memory structure 152 can be configured in a shared staircase structure having two sides, and the two sides can be symmetrical when viewed in cross-section as illustrated in Fig. 1.

The staircases of the NOR memory structure 102 and the NAND memory structure 152 located between the array of vertical NOR columns and the array of vertical NAND columns.

The word line layers 104 within the NOR memory structure 102 are arranged in one side of the symmetrical staircase configuration, such that word line contacts 107 can access individual word line layers 104.

The word line layers 154 within the NAND memory structure 152 are arranged in the other side of the symmetrical staircase configuration, such that word line contacts 157 can access individual word line layers 154.

Figs. 4A, 4B1, 4B2, 4C, 4D, 4E, 4F, 4G, 4H, 41, 4J, 4J1, 4K, 4L, 4M, and 4N illustrate stages in a manufacturing process usable to manufacture the semiconductor memory device 100 of Figs. 1-3D.

Fig. 4A illustrates a subassembly after providing a substrate 101 including logic circuits 103, 153 and a buffer layer 193 *(e.g.,* silicon nitride/silicon oxide) and a metallization layer 195 for the underlying CMOS peripheral circuits. In an example, the buffer layer 193 and metallization layer 195 may also act as buffer layers, to prevent or reduce transmission of mechanical and/or thermal shocks generated during manufacturing of the NAND/NOR memory arrays to the logic circuits 103, 153.

A stack 190 of alternate conductive layers 191 (e.g., conductive layers 191a, 191b, 191c, as discussed herein previously) and dielectric layers 192 (e.g., dielectric layers 192a, 192b) are formed in an area over the substrate including buffer layer 193 and metallization layer 195. In an example, the conductive layers 191 comprise conductive material, such as polysilicon, tungsten, or an appropriate metal or metal alloy. Subsequently, a plurality of alternating insulating layers 106 and sacrificial layers 402 is formed over the area of the substrate. Note that the sacrificial layers 402 are to be later in the process replaced by corresponding word line layers 104, 154. The material of the sacrificial layers 402 can be any appropriate sacrificial material, such as silicon nitride. As previously discussed herein, the insulating layers 106 comprise appropriate insulating material, such as silicon oxide.

Fig. 4B1 illustrates a subassembly formed from the subassembly of Fig. 4A. In Fig. 4B1, the plurality of alternating insulating layers 106 and the sacrificial layers 402 of Fig. 4A is etched to partition it into first and second stacks 403a, 403b, and to form the stepped or staircase structure for word line contacts in the NAND and NOR memories being formed. For example, a sacrificial layer 402 is etched and partitioned to form two corresponding separate and discontinuous sacrificial layers 404 and 454 that are in the same horizontal plane, and part of a same patterned layer. Thus, the subassembly now has a first stack 403a of alternating sacrificial layers 404 and insulating layers 106; and a second stack 403b of alternating sacrificial layers 454 and insulating layers 156.

The stack 403a including the sacrificial layers 404 are in the NOR section of the memory array, and the stack 403b including the sacrificial layers 454 are in the NAND section of the memory array. Sacrificial layers 404 of sacrificial material are to be later replaced to form word line layers 104 of the NOR memory structure 102. Sacrificial layers 454 of sacrificial material are to be later replaced to form word line layers 154 of the NAND memory structure 152.

Furthermore, in the example of Fig. 4B1, the conductive layers 191a, 191b, 191c (e.g., which comprise conductive material) are not etched to separate sections underneath the sacrificial layers 404 and underneath the sacrificial layers 454. Rather in the case in which the conductive layers 191a, 191b, 191c are semiconductor material, a first section of the conductive layers 191a, 191b, 191c underneath the sacrificial layers 404 is electrically isolated from a second section of the conductive layers 191a, 191b, 191c underneath the sacrificial layers 454, e.g., via ion implantation in a region 407 between the two sections. For example, a polarity of the implanted ion is selected such that the two sections of the conductive layers 191 are electrically isolated by the region 407.

Fig. 4B2 illustrates an alternative manner to electrically isolate the above discussed first and second sections of the conductive layers 191a, 191b, 191c. For example, in Fig. 4B2, instead of ion implementation, the conductive layers 191a, 191b, 191c are selectively etched and partitioned in two discontinuous sections, such that the two sections are physically separated.

At least some of the remaining figures assume that the above discussed two sections of the conductive layers 191a, 191b, 191c are isolated using the ion implantation discussed with respect to Fig. 4B1. However, such an assumption does not limit the scope of this disclosure, and the two sections can also be isolated using the physical separation of the two sections discussed with respect to Fig. 4B2 (and as also discussed herein later with respect to Fig. 5).

Fig. 4C illustrates a subassembly formed from the subassembly of Fig. 4B1, in which an appropriate insulating material 420, such as a silicon oxide, is deposited in the area between the stepped or staircase sacrificial layers 404 and 454. The insulating material 420 is planarized using CMP (Chemical Mechanical Polishing) and/or other polishing or planarization techniques, as illustrated in Fig. 4C.

Fig. 4D illustrates a subassembly formed from the subassembly of Fig. 4C, in which a patterned mask or photoresist layer 417 is deposited on an upper surface of the subassembly. Subsequently, the subassembly is etched through openings in the photoresist layer 417, thereby forming first and second arrays of in the first and second stacks (102 and 105), including vertical openings 405, 406, 408, 409 illustrated in the figure. Any appropriate anisotropic etching technique may be used for forming the vertical openings 405, 406, 408, 409.

Referring to Figs. 1 and 4D, the vertical opening 405 is for the section 200a that will eventually include the NOR through-hole interconnect 219; the vertical opening 406 is for the section 200 that will eventually include the NOR channel layer 209; the vertical opening 408 is for the section 300 that will eventually include the NAND channel layer 309; and the vertical opening 409 is for the section 300a that will eventually include the NAND interconnect 169.

Diameters of the vertical openings 405, 406, 408, and 409 are labelled as D4, D2, D1, and D3, respectively, in Fig. 4D. In an example, diameters D3 and D4 are substantially similar. In an example, diameters D3 and D4 are in the range of 300-400 nanometers (nm). In an example, diameter D2 is less than the diameters D3 and D4, and diameter D1 is less than diameter D2. That is, D1 < D2 < D3≅ D4. In an example, diameter D1 can be in the range of 75-125 nm, and diameter D2 can be in the range of 150-250 nm.

In an embodiment, the diameters D3 and D4 are relatively wider, because these are used for relatively thick through-hole interconnect structures for communicating with the logic circuits 103, 153 underneath the memory array. The diameter D2 is larger than the diameter D1, as the NOR channel opening having the diameter D2 has to accommodate two conductive pillars (such as conductive pillars 204, 205, see Figs. 2B, 2C), whereas the NAND channel opening having the diameter D1 has to accommodate only one memory pillar (see Fig. 3B).

Referring now to Fig. 4E, a data storage structure is deposited on sidewalls of each of the vertical openings 405, 406, 408, 409, and subsequently channel material is deposited on sidewalls of each of the vertical openings 405, 406, 408, 409.

For example, referring to Figs. 2B, 2C, and 4E, in the NOR side of the memory structure, data storage structure 208 is deposited on the sidewalls of the vertical opening 406, followed by deposition of the channel layer 209. The data storage structure in the NOR side and the data storage structure in the NAND side can be made using the same manufacturing steps, and can be substantially the same layers of materials having substantially the same thicknesses, varying basically due to variations across the area of the processes and due to differences in the vertical openings.

Similarly, referring to Figs. 3A and 4E, in the NAND side of the memory structure, data storage structure 308 is deposited on the sidewalls of the vertical opening 408, followed by deposition of the channel layer 309. Note that this results in formation of the memory pillar of the NAND memory within the vertical opening 408. Accordingly, a top plug 315 may be formed on top of the vertical opening 408, as also discussed with respect to Fig. 3.

Similarly, in an example, data storage structures 208 and channel layers 209 are deposited on sidewalls of the vertical openings 405, 409, as illustrated in Fig. 4E, and as discussed with respect to Figs. 2E, 2F. However, in another example and contrary to the illustrations of Fig. 4E, no data storage structure and/or channel layer may be deposited in the vertical openings 405, 409, as discussed with respect to Figs. 2E1 and 2F1.

In an embodiment, the data storage structure (208, 308) deposition is performed at least in part simultaneously in each of the vertical openings 405, 406, 408, 409. Thus, the data storage structure (208, 308) is deposited in a same process step in all of the vertical openings 405, 406, 408, 409. Thus, the data storage structure in the NOR side and the data storage structure in the NAND side can be made using the same manufacturing steps, and can be substantially the same layers of materials having substantially the same thicknesses, varying basically due to variations across the area of the processes and due to differences in the vertical openings.

Similarly, in an embodiment, the channel layer (209, 309) deposition is performed at least in part simultaneously in each of the vertical openings 405, 406, 408, 409. Thus, the channel layer (209, 309) is deposited in a same process step in all of the vertical openings 405, 406, 408, 409. Thus, the channel layer in the NOR side and the channel layer in the NAND side can be made using the same manufacturing steps, and can be substantially the same materials having substantially the same thicknesses, varying basically due to variations across the area of the processes and due to differences in the vertical openings.

As illustrated in Fig. 4E, the data storage structures (208, 308) and the channel layers (209, 309) are present on sidewalls, but not on the bottom surface, of each of the vertical openings 405, 406, and 409. For example, after deposition of the data storage structure and the channel layer on the sidewalls and bottom surface of each of the vertical openings 405, 406, and 409, the data storage structure and the channel layer may be etched using directional or anisotropic etching techniques from the bottom surfaces of these vertical openings, thereby leaving these layers on the sidewalls (bot not on the bottom surfaces) of these vertical openings 405, 406, 409.

In contrast, in the vertical opening 408, the data storage structure 308 and the channel layer 309 are present on both sidewalls and bottom surface of the vertical opening 408.

In an example, the vertical openings 405 and 409, which are to be used for interconnect structures to access under-memory array logic circuits, are filled with insulating material, such as silicon oxide, or a sacrificial material such as silicon nitride (not labelled in Fig. 4E). In an example, the vertical opening 406, which is to be used for NOR channel formation, may be filled with insulating material (such as silicon oxide) or a sacrificial material (such as silicon nitride), or left unfilled for further processing (e.g., discussed with respect to Fig. 4F).

Referring now to Fig. 4F, two vertical holes are etched in the Z-direction within the insulating material within the vertical opening 406, and conductive pillars 204 and 205 are respectively formed within the two vertical holes using an appropriate deposition process. The structure of the conductive pillars 204 and 205 are discussed in detail with respect to Figs. 2B, 2C. This completes formation of the section 200 of the NOR memory, which includes the channel layer 209 of the NOR memory.

Referring now to Fig. 4G, vertical openings or slits 109a, 109b, 109c, 159a, 159b are formed in the z-direction, as illustrated in the figure. In an example, vertical openings 109a, 109b, and 109c extend through the stack 403a of the alternating insulating layers 106 and sacrificial layers 404 on the NOR side of the array; and vertical openings 159a and 159b extend through the stack 403b of the alternating insulating layers 156 and sacrificial layers 454 on the NAND side of the array. The vertical openings 109a, 109b, 109c, 159a, 159b extend up to the conductive layer 191b (e.g., which is a middle one of the three conductive layers 191a, 191b, 191c). In an example, the vertical openings 109a, 109b, 109c, 159a, 159b are formed by patterning a photoresist layer on the subassembly, and then forming the vertical openings using a directional or anisotropic etching technique through openings in the patterned photoresist layer.

The vertical opening 109c has a diameter of DS2, each of the vertical openings 109a, 109b has a diameter of about DS1, and each of the vertical openings 159a, 159b has a diameter of about DS3. In an example, the diameter DS1 is smaller than each of DS2 and DS3. The diameter DS2 is substantially equal to, or slight less than the diameter DS3. Put differently, DS1 < DS2 ≅< DS3.

As will be discussed herein later, the vertical openings 109a, 109b are to be used for removal of the sacrificial layers 404 and subsequent deposition of word line material, and these vertical openings are not to be used for any subsequent electrical operation. Accordingly, these vertical openings have a relatively smaller diameter (e.g., compared to the vertical openings 109c, 159a, 159b).

In contrast, the vertical openings 109c, 159a, and 159b are to be used for removal of the sacrificial layers 404 and subsequent deposition of word line material, and these vertical openings are also to be used for other electrical connection purposes and various other purposes discussed herein later. Accordingly, the vertical openings 109c, 159a, and 159b have a relatively larger diameter (e.g., compared to the vertical openings 109a and 109b).

Referring now to Fig. 4H, the sidewalls and the bottom surface of the vertical openings 109c, 109a, 109b, 159a, 159b are lined with etching stop layer 428 comprising, for example, silicon nitride or another appropriate etching stop material. An appropriate deposition technique can be applied to deposit the etching stop layer 428 on the sidewalls and the bottom surface of the vertical openings 109c, 109a, 109b, 159a, 159b. The etching stop layer 428 on the bottom surfaces of the vertical openings 109c, 159a, 159b are removed, e.g., by employing an appropriate anisotropic etching technique. Thus, the etching stop layer 428 remains on the bottom surfaces of the vertical openings 109a, 109b, but not on the vertical openings 109c, 159a, 159b, as illustrated in Fig. 4H.

Referring now to Fig. 41, sections of the conductive layer 191b and adjacent sections of the dielectric layers 192a and 192b are etched and removed through the vertical openings 109c, 159a, and 159b. Thus, a void 443 is formed underneath the vertical opening 109c, where the void 443 is within a corresponding section of the conductive layer 191b and adjacent sections of the dielectric layers 192a and 192b. Similarly, a void 483 is formed underneath the vertical openings 159a, 159b, where the void 483 is within a corresponding section of the conductive layer 191b and adjacent sections of the dielectric layers 192a and 192b.

Note that sections of the data storage structure 308 of the vertical opening 408, which are adjacent to the conductive layer 191b and the dielectric layers 192a, 192b, are also removed, such that the channel layer 309 is exposed through the void 483.

Referring now to Fig. 4J, the void 443 is refilled (e.g., through the vertical opening 109c) with conductive material, to form the conductive structure 143. The conductive structure 143 is physically coupled to, and electrically connects, the conductive layers 191a, 191b, 191c underneath the left section of the subassembly (e.g., underneath the sacrificial layers 404). As discussed with respect to Fig. 2G, because the conductive layers 191a, 191b, 191c are coupled to each other through the conductive structure 143, a combination of the conductive layers 191a, 191b, 191c can now form a gate for the dummy cell 144 (see Fig. 2G).

Similarly, the void 483 is refilled (e.g., through the vertical openings 159a, 159b) with conductive material, to form conductive source line (SL) structure 183. The SL structure 183 is physically coupled to, and electrically connects, the conductive layers 191a, 191b, 191c underneath the right section of the subassembly (e.g., underneath the sacrificial layers 454). The SL structure 183 makes direct contact with the channel layer 309 (e.g., as the data storage structure 308 adjacent to the void 483 was removed, as discussed with respect to Fig. 41). That is, the data storage structure 308 is absent between the SL structure 183 and the channel layer 309, and the SL structure 183 can directly control the channel layer 309.

The etching stop layers 428 are also removed from the vertical openings 109c, 109a, 109b, 159a, and 159b. While removing the etching stop layers 428 from sidewalls of the vertical openings 109c, 159a, 159b, any remnants of the conductive structure 143 and the SL structure 183 are also removed from the sidewalls of these vertical openings.

Referring now to Fig. 4J1, the sacrificial material of the sacrificial layers 404 are removed through the vertical openings 109c, 109a, 109b, resulting in voids that are labelled as 464. Thus, now voids 464 and the insulating layers 106 are interleaved in a stack 477a in the NOR section of the memory structure.

Similarly, the sacrificial material of the sacrificial layers 454 are removed through the vertical openings 159a, 159b, resulting in voids that are labelled as 474. Thus, now voids 474 and the insulating layers 156 are interleaved in a stack 477b in the NAND section of the memory structure.

Referring now to Fig. 4K, the voids 464 are filled with word line material (such as tungsten) through the vertical openings 109c, 109a, 109b, to form corresponding word line layers 104 in the NOR section of the memory structure. Similarly, the voids 474 are filled with word line material (such as tungsten) through the vertical openings 159a, 159b, to form corresponding word line layers 154 in the NAND section of the memory structure. Thus, the stack 105 of alternating insulating layers 106 and word line layers 104 are formed in the NOR section, and the stack 155 of alternating insulating layers 156 and word line layers 154 are formed in the NAND section. Note that a same or temporally overlapping word line deposition process may be employed, to at least in part concurrently form the word line layers in both the NOR and NAND sections of the array.

Note that a word line of the NOR memory structure 102 will have a corresponding word line of the NAND memory structure 152, such that these two word-lines are in the same horizontal plane, and part of a same patterned layer. This is because the two word-lines are formed by replacing corresponding two sacrificial layers that were initially part of a single sacrificial layer, e.g., as illustrated in Fig. 4A and 4B1.

Referring now to Fig. 4L, conductive material is deposited in the vertical openings 159a, 159b, to respectively form interconnects 161a, 161b comprising conductive material, such as tungsten, copper, aluminum, gold, silver, or another appropriate metal or metal alloy, or a non-metal conductive material such as polysilicon. The interconnect 161a is separated from the sidewalls of the vertical opening 159a by insulating material (not labelled in Fig. 4L). Similarly, the interconnect 161b is separated from the sidewalls of the vertical opening 159b by insulating material (not labelled in Fig. 4L). In an example, the interconnects 161a and/or 161b act(s) as source line contacts, to couple the SL structure 183 to circuits on top of the NAND memory structure 152.

In an example, conductive material is deposited in the vertical opening 109c, to form a dummy gate contact 111 extending downward in the Z-direction through the vertical opening 109c. The dummy gate contact 111 comprises conductive material, such as tungsten, copper, aluminum, gold, silver, or another appropriate metal or metal alloy, or a non-metal conductive material such as polysilicon. The dummy gate contact 111 is separated from the sidewalls of the vertical opening 109c by insulating material (not labelled in Fig. 4L), which can be, for example, an appropriate oxide, such as silicon oxide.

However, in another example and although not illustrated in Fig. 4L, the vertical opening 109c is filled with insulating material, such as silicon oxide. In such an example, the vertical opening 109c lacks any dummy gate contact, and contact 108 (see Figs. 1 and 2A) acts as a dummy gate contact, as discussed herein previously with respect to Figs. 2G.

The vertical openings 109a, 109b are filled with insulating material, such as silicon oxide, as illustrated in Fig. 4L (the insulating material in these vertical openings are not specifically labelled in Fig. 4L), as these vertical openings are not used for any electrical connections of the device 100.

Referring now to Fig. 4M, word line contacts 107 for the NOR memory structure 102 and word line contacts 157 for the NAND memory structure 152 are formed, e.g., by deep etching of the insulating material 420. In an example, dummy gate contact 108 is also formed, whereas in another example, no such dummy gate contact is formed (e.g., the contact 111 acts as a dummy gate contact), as discussed with respect to Fig. 2G.

Furthermore, through-hole interconnect 219 is formed in the vertical opening 405, e.g., to access the logic circuits 103 from top of the NOR memory structure 102, as discussed in further detail with respect to Fig. 2A. Similarly, through-hole interconnect 169 is formed in the vertical opening 409, e.g., to access the logic circuits 153 from top of the NAND memory structure 152, as discussed in further detail with respect to Fig. 3A

Referring now to Fig. 4N, top interconnections are formed on the subassembly, which couples the various connection structures of Fig. 4M to circuits and metallization layers on top of the memory array. The subassembly illustrated in Fig. 4N is the semiconductor memory device 100 of Fig. 1. This completes the manufacturing process to form the semiconductor memory device 100 of Fig. 1.

As discussed herein previously, a first section of the conductive layers 191 at a bottom portion of the NOR memory structure 102 and a second section of the conductive layers 191 at a bottom portion of the NAND memory structure 152 can be electrically isolated by, for example, physically separating these two sections or by ion implantation in a region of the layers between these two sections. Ion implantation has been discussed with respect to region 407 of Fig. 4B1. Fig. 5 illustrates the semiconductor memory device 100 of Fig. 1, where a first section of the conductive layers 191 underneath the NOR memory structure 102 and a second section of the conductive layers 191 underneath the NAND memory structure 152 are physically separated. For example, a vertical opening 502 between these two sections separate the two sections. The vertical opening 502 can be filled with insulating material 420 discussed herein previously. The vertical opening 502 can be formed by forming a series of wells or slits that fully separate and isolate a first section of the conductive layer 191a from a second section of the conductive layer 191a, that fully separate and isolate a first section of the conductive layer 191b from a second section of the conductive layer 191b, and that fully separate and isolate a first section of the conductive layer 191c from a second section of the conductive layer 191c. In an example, the vertical opening 502 can be formed during formation of the vertical openings 109a, 109b, 109c, 159a, 159b, as discussed with respect to Fig. 4G herein previously.

Fig. 5 also illustrates an alternative embodiment in which the layer 111 (previously referred to as dummy gate contact, and was used as dummy gate contact in Fig. 1) within the vertical opening 109c is not coupled to the top of the array circuits. For example, Fig. 5 lacks the interconnect structures 235 of Fig. 2G. The layer 111 in the example of Fig. 5 can comprise conductive or insulating material, and is not used for any electrical connection of the NOR memory. The contact 108 acts as a dummy gate contact for the embodiment illustrated in Fig. 5.

Referring to Figs. 1-5, disclosed herein is a semiconductor memory device 100 that integrates the NOR memory structure 102 and the NAND memory structure 152 in a same IC memory chip. The NOR memory structure 102 and the NAND memory structure 152 are manufactured using the same process, and at least in part simultaneously. For example, the process discussed herein for formation of the channel layers of the NAND and NOR memory, for formation of the various vertical openings, and the contact formation process are highly integrated, to meet the requirement for both NOR and NAND architectures, without complicatedly duplicating the same process once for NOR and once for NAND. For example, as discussed with respect to Fig. 4G, the vertical openings or slits 109a, 109b, 109c for the NOR memory structure 102 and the vertical openings or slits 159a, 159b for the NAND memory structure 152 are formed in the same vertical opening formation process step. Similarly, the channel layer and data storage structure formation for both the NOR memory structure 102 and the NAND memory structure 152 are executed at least in part concurrently (e.g., executed during the same process step), as discussed with respect to Fig. 4E. Similarly, the through-hole interconnect 219 of the NOR memory structure 102 and the through-hole interconnect 169 of the NAND memory structure 152 are formed during the same process step. Therefore, the overall manufacturing steps are reduced due to various common operation steps of the NOR and NAND memory, and consequently the cost and/or time for manufacturing the device 100 is correspondingly reduced.

As discussed with respect to Fig. 4B1, the conductive layers 191 at a bottom portion of the NOR section and at a bottom portion of the NAND section can be electrically isolated from each other using ion implantation in the region 407. Thus, the NOR memory structure 102 and the NAND memory structure 152 are on the same continuous section of the conductive layers 191, i.e., on a same memory tile in the example of Fig. 1. In contrast, in the example of Fig. 5, the NOR memory structure 102 and the NAND memory structure 152 are on two different memory tiles. Such alternatives provide greater flexibility in the chip design and arrangement.

The semiconductor device 100 of Fig. 1 can be used for applications in which a combination of NOR and NAND memory is desired. For example, the NOR memory structure 102 allows relatively fast read, random-access times, reliable code storage, and ease-of-use (e.g., compared to NAND memory), and may be suitable for execute-in-place applications, BIOS, and firmware applications. On the other hand, the NAND memory structure 152 generally features relatively faster write operations (e.g., write by page) and erase operations (e.g., erase by block), are relatively low cost-per-bit and has relatively higher density (e.g., compared to NOR memory), and may be used for data storage applications.

In an example, the combination of the NOR memory structure 102 and the NAND memory structure 152 can be used as a single combined memory device. Such a combined memory device can be used for the so called "execute in place" (XIP) applications and/or "compute in memory" (CIM) applications, in which the combined memory device can be used as a computing component or as an Artificial Intelligence (AI) computing component. For example, such a combined memory device can be in package with a central computing device (like a Central Processing Unit or CPU), to form a local computing system.

Fig. 6A illustrates an example in which the semiconductor memory device 100 of Fig. 1 is used for "compute in memory" (CIM) applications. In the example of Fig. 6A, the NOR memory structure 102 and/or the NAND memory structure 152 stores a plurality of weights, such as weights W1, W2, ..., WM. The semiconductor memory device 100 receives inputs X1, X2, ..., XM, and generates an output O. In an example where the semiconductor memory device 100 implements a CIM application, the output O is generated to be a function of the inputs X1, X2, ..., XM and weights W1, W2, ..., WM.

For example, the semiconductor memory device 100 can be used for computations based on linear algebra, such as to implement multiply-and-accumulate function, or sum-of-products function. Such functions are often used in neuromorphic computing systems, and machine learning systems and circuitry. An example of such functions can be expressed as follows:

$$O = f(X_i, W_i)_{i=1,\dots,M} = \sum_{i=1}^{M} W_i . X_i$$

Thus, in this example, the output is a sum-of-product of the input and the weights stored in the semiconductor memory device 100. Further details of compute-in-memory application may be found in co-pending U.S. patent application number 16/359,919, entitled "NON-VOLATILE COMPUTING METHOD IN FLASH MEMORY," filed on March 20, 2019, which is incorporated by reference in its entirety.

Fig. 6B illustrates an example system 600 that includes the semiconductor memory device 100 of Figs. 1-6A, in which the semiconductor memory device 100 is used for CIM applications. In an example, the system 600 comprises a host 620, which may be a Central Processing Unit (CPU), a Graphic Processing Unit (GPU), or the like. The host 620 communicates with the semiconductor memory device 100 directly and/or via a Random Memory Access (RAM) memory 622 (although not illustrated, there may be other circuits, such as a memory controller, between the host 620 and the memory device 100). In the system 600, the NAND memory structure 152 and/or the NOR memory structure 102 shares computing load of the host 620, e.g., by executing computations, as discussed with respect to Figs. 6A. Examples of such computations include, but are not limited to, multiply-and-accumulate function, sum-of-products function, and/or the like. Thus, the semiconductor memory device 100 is able to reduce computational load of the host 620, by executing some of the computations within the NOR and/or NAND memory.

Figs. 7 illustrates a system that includes the semiconductor memory device 100 of Figs. 1-6B, where a host 720 communicates with the semiconductor memory device 100 directly (e.g., by bypassing a RAM 722), and where the semiconductor memory device 100 can implement "execute in place" (XIP) functions (although not illustrated, there may be other circuits, such as a memory controller, between the host 720 and the memory device 100).

For example, conventionally NOR and NAND memory are not combined, and these memories act as stand-alone memory. In a conventional file system without the XIP function, the initial program code stored in load address (e.g., in a non-volatile memory or NVM) has to be initialized. The RAM system may set up an available size in execute address, combined with the program code and other data, forming image for execution in the CPU.

In contrast, in the XIP function of the semiconductor memory device 100, since the NOR has random access ability, the stored program code with the load address can execute, without having to move the code to the RAM 722. Therefore, the code can be executed in place where it is stored in the NOR memory structure 102, i.e., without having to occupy storage in the RAM 722. The return data or code (such as execute read function in memory) can be transferred to the host 720, combined with other information (such as variable or data) from the RAM 722, for further computing in the host 720. Therefore, Fig. 7 shows direct communication path between the host 720 and the memory device 100. A path between the RAM 722 and the NOR memory structure 102 of the memory device 100 can be skipped for XIP functions (such as system boot-up or some other XIP file system). In another example, the path between the RAM 722 and the NOR memory structure 102 can be still reserved for other non-XIP file system requirement. In the example of Fig. 7, thus, the host 720 directly communicates with the semiconductor memory device 100. This enables the semiconductor memory device 100 to implement XIP functions, such as the CIM functions discussed with respect to Fig. 6A.

While the present invention is disclosed by reference to the preferred embodiments and examples detailed above, it is to be understood that these examples are intended in an illustrative rather than in a limiting sense. It is contemplated that modifications and combinations will readily occur to those skilled in the art, which modifications and combinations will be within the spirit of the invention and the scope of the following claims. What is claimed is:

## Claims

**1.** A semiconductor memory device (100), comprising:

a substrate (101);
a plurality of word line layers (104, 154) over the substrate (101);
an array of vertical NOR columns in a first area of the plurality of word line layers (104, 154), each vertical NOR column in the array of vertical NOR columns including a first conductive pillar (204, 205) and a second conductive pillar (204, 205), and comprising a first plurality of memory cells (220, 220a, 220b, 220c, 320, 320a, 320b, 320c) arranged in a NOR configuration formed at cross points of word line layers (104, 154) in the plurality of word line layers (104, 154) with the first and second conductive pillars (204, 205); and
an array of vertical NAND columns in a second area of the plurality of word line layers (104, 154), each vertical NAND column in the array of vertical NAND columns including a memory pillar, and comprising a second plurality of memory cells (220, 220a, 220b, 220c, 320, 320a, 320b, 320c) arranged in a NAND configuration formed at cross points of the word line layers (104, 154) in the plurality of word line layers (104, 154) with the memory pillar.

**2.** The semiconductor memory device (100) of claim 1, further including a stairstep contact structure dividing the plurality of word line layers (104, 154) between the first and second areas, the stairstep contact structure having first side contacting the plurality of word line layers (104, 154) in the first area including array of vertical NOR columns, and a second side contacting the plurality of word line layers (104, 154) in the second area including array of vertical NAND columns.

**3.** The semiconductor memory device (100) of claim 1, wherein:

the plurality of word line layers (102, 152) includes a first stack (102, 105, 152, 155, 190, 403a, 403b, 477a, 477b) of word line layers (104, 154) in the first area, with a first vertical opening (109a, 109b, 109c, 159a, 159b, 405, 406, 408, 409, 502) extending through the word line layers (104, 154) of the first stack (102, 105, 152, 155, 190, 403a, 403b, 477a, 477b), wherein the first conductive pillar (204, 205) and the second conductive pillar (204, 205) are within the first vertical opening (109a, 109b, 109c, 159a, 159b, 405, 406, 408, 409, 502); and
the plurality of word line layers (104, 154) includes a second stack (102, 105, 152, 155, 190, 403a, 403b, 477a, 477b) of word line layers (104, 154) in the second area, with a second vertical opening (109a, 109b, 109c, 159a, 159b, 405, 406, 408, 409, 502) extending through the word line layers of the second stack (102, 105, 152, 155, 190, 403a, 403b, 477a, 477b), wherein the memory pillar is within the second vertical opening.

**4.** The semiconductor memory device (100) of claim 3, further including a symmetrical stair step contact area between the first stack and the second stack (109a, 109b, 109c, 159a, 159b, 405, 406, 408, 409, 502).

**5.** The semiconductor memory device (100) of claim 1, further comprising:
at least one conductive layer (191) underneath the plurality of word line layers (104, 154) in the first area acting as a gate of a dummy cell (144) of a vertical NOR column in the array of vertical NOR columns.

**6.** The semiconductor memory device (100) of claim 5, further comprising a dummy gate contact (111) through the plurality of word line layers (104, 154) connected to the at least one conductive layer (191).

**7.** The semiconductor memory device (100) of claim 1, further comprising:
at least one conductive layer (191) underneath the plurality of word line layers (104, 154) in the second area acting as a source line (SLn, SL(n+1)) connected to a vertical channel of a vertical NAND column in the array of vertical NAND columns.

**8.** The semiconductor memory device (100) of claim 7, further comprising a source line contact through the plurality of word line layers (104, 154) connected to the at least one conductive layer (191).

**9.** The semiconductor memory device (100) of claim 1, further comprising:

a first set of conductive material layers underneath the plurality of word line layers (104, 154) in the first area;
a first conductive material structure that electrically couples the conductive material layers of the first set, wherein the electrically coupled conductive material layers of the first set act as a gate of a dummy cell (144) of a vertical NOR column in the plurality of vertical NOR columns;
a second set of conductive material layers underneath the plurality of word line layers (104, 154) in the second area;
a second conductive material structure that electrically couples the conductive material layers of the second set, wherein the electrically coupled conductive material layers of the second set act as a source line (SLn, SL(n+1)) connected to a vertical NAND column in the plurality of vertical NAND columns.

**10.** The semiconductor memory device (100) of claim 9, wherein:
one of the first conductive material layers of the first set and one of the second conductive material layers of the second set are at least in part on a same horizontal plane.

**11.** The semiconductor memory device (100) of claim 1, wherein the substrate (101) is a single Integrated Circuit (IC) memory chip.

**12.** An Integrated Circuit (IC) chip, comprising:

a substrate (101);
a three-dimensional (3D) NOR over the substrate (101) having a first word line (WL, WLi, WL(i)m, WL(i)(m+1)); and
a three-dimensional (3D) NAND on the substrate (101) having a second word line (WL, WLi, WL(i)m, WL(i)(m+1)),
wherein the first word line (WL, WLi, WL(i)m, WL(i)(m+1)) and the second word line (WL, WLi, WL(i)m, WL(i)(m+1)) are part of a same patterned layer.

**13.** The IC chip of claim 12, wherein the first word line (WL, WLi, WL(i)m, WL(i)(m+1)) and the second word line (WL, WLi, WL(i)m, WL(i)(m+1)) are at least in part on a same horizontal plane.

**14.** The IC chip of claim 12, wherein the 3D NOR comprises:

a first stack (102, 105, 152, 155, 190, 403a, 403b, 477a, 477b) of word line layers (104, 154) with a vertical NOR column through the first stack (102, 105, 152, 155, 190, 403a, 403b, 477a, 477b),
a first conductive pillar (204, 205) and a second conductive pillar (204, 205) inside the vertical NOR column, and separated from each other by an insulating filling layer (211),
a first data storage structure (208, 308) disposed on a perimeter of the vertical NOR column and contacting inside surfaces of the word line layers (104, 154) of the first stack (102, 105, 152, 155, 190, 403a, 403b, 477a, 477b), and
a first channel layer (209, 309) disposed on the first data storage structure (208, 308) around a perimeter of the vertical NOR column, and having first and second contacts contacting with the first and second conductive pillars (204, 205), respectively; and
wherein the 3D NAND comprises:

a second stack (102, 105, 152, 155, 190, 403a, 403b, 477a, 477b) of word line layers (104, 154) with a vertical NAND column through the second stack (102, 105, 152, 155, 190, 403a, 403b, 477a, 477b),
a channel layer (209, 309) extending along and inside the vertical NAND column; and
a second data storage structure (208, 308) disposed on a perimeter of the channel layer (209, 309) of the vertical NAND column and contacting inside surfaces of the word line layers (104, 154) of the second stack (102, 105, 152, 155, 190, 403a, 403b, 477a, 477b).

**15.** A method of manufacturing a vertical memory structure (102, 152), comprising:

forming alternating insulating layers (106) and sacrificial layers (402) covering an area on a substrate (101);
partitioning the alternating insulating layers (106) and sacrificial layers (402) covering the area, to form a first stack (102, 105, 152, 155, 190, 403a, 403b, 477a, 477b) of alternating insulating layers (106) and sacrificial layers (404, 454) and a second stack (102, 105, 152, 155, 190, 403a, 403b, 477a, 477b) of alternating insulating layers (106) and sacrificial layers (404, 454); and
forming a vertical NOR memory array within the first stack (102, 105, 152, 155, 190, 403a, 403b, 477a, 477b) and a vertical NAND memory array within the second stack (102, 105, 152, 155, 190, 403a, 403b, 477a, 477b), including replacing the sacrificial layers (404, 454) of the first stack (102, 105, 152, 155, 190, 403a, 403b, 477a, 477b) and the second stack (102, 105, 152, 155, 190, 403a, 403b, 477a, 477b) with word line material.

**16.** The method of claim 15, wherein replacing the sacrificial material comprises:
replacing the sacrificial material of the first stack (102, 105, 152, 155, 190, 403a, 403b, 477a, 477b) and of the second stack (102, 105, 152, 155, 190, 403a, 403b, 477a, 477b) during a same replacement process.

**17.** The method of claim 15, further comprising:

forming an array of vertical openings (109a, 109b, 109c, 159a, 159b, 405, 406, 408, 409, 502) in the first and second stacks (102, 105, 152, 155, 190, 403a, 403b, 477a, 477b) during a same vertical opening formation process, the array including a first vertical opening (109a, 109b, 109c, 159a, 159b, 405, 406, 408, 409, 502) in the first stack (102, 105, 152, 155, 190, 403a, 403b, 477a, 477b) for formation of a column of NOR cells and a second vertical opening (109a, 109b, 109c, 159a, 159b, 405, 406, 408, 409, 502) in the second stack (102, 105, 152, 155, 190, 403a, 403b, 477a, 477b) for formation of a string of NAND cells;
forming a first data storage structure lining within the first vertical opening (109a, 109b, 109c, 159a, 159b, 405, 406, 408, 409, 502) in the first stack (102, 105, 152, 155, 190, 403a, 403b, 477a, 477b) for formation of a column of NOR cells and a second vertical opening (109a, 109b, 109c, 159a, 159b, 405, 406, 408, 409, 502) and a second data storage structure lining within the second vertical opening (109a, 109b, 109c, 159a, 159b, 405, 406, 408, 409, 502) in the second stack (102, 105, 152, 155, 190, 403a, 403b, 477a, 477b) for formation of a column of NOR cells and a second vertical opening (109a, 109b, 109c, 159a, 159b, 405, 406, 408, 409, 502); and
forming a first channel layer (209, 309) on the first data storage structure lining in the first vertical opening (109a, 109b, 109c, 159a, 159b, 405, 406, 408, 409, 502) and a second channel layer (209, 309) on the second data storage structure lining in the second vertical opening (109a, 109b, 109c, 159a, 159b, 405, 406, 408, 409, 502).

**18.** The method of claim 17, further comprising:
forming a first conductive pillar (204, 205) and a second conductive pillar (204, 205) inside the first vertical opening (109a, 109b, 109c, 159a, 159b, 405, 406, 408, 409, 502) contacting the first channel layer (209, 309), wherein in the column of NOR cells in the first vertical opening (109a, 109b, 109c, 159a, 159b, 405, 406, 408, 409, 502) are connected in parallel between the first and second conductive pillars (204, 205).

**19.** The method of claim 17, further comprising:

during the same vertical opening formation process, forming a third vertical opening (109a, 109b, 109c, 159a, 159b, 405, 406, 408, 409, 502) in the first stack (102, 105, 152, 155, 190, 403a, 403b, 477a, 477b) and a fourth vertical opening (109a, 109b, 109c, 159a, 159b, 405, 406, 408, 409, 502) in the second stack (102, 105, 152, 155, 190, 403a, 403b, 477a, 477b);

forming a third data storage structure lining on surfaces of the layers of sacrificial material exposed through the third vertical opening (109a, 109b, 109c, 159a, 159b, 405, 406, 408, 409, 502) in the first stack (102, 105, 152, 155, 190, 403a, 403b, 477a, 477b) and a fourth data storage structure lining on surfaces of the layers of sacrificial material exposed through the fourth vertical opening (109a, 109b, 109c, 159a, 159b, 405, 406, 408, 409, 502) in the second stack (102, 105, 152, 155, 190, 403a, 403b, 477a, 477b);

forming a third channel layer (209, 309) on the third data storage structure (208, 308) around a perimeter of the third vertical opening (109a, 109b, 109c, 159a, 159b, 405, 406, 408, 409, 502) and a fourth channel layer (209, 309) on the fourth data storage structure (208, 308) around a perimeter of the fourth vertical opening (109a, 109b, 109c, 159a, 159b, 405, 406, 408, 409, 502);

forming a first through-hole interconnect (169, 219) within the third vertical opening (109a, 109b, 109c, 159a, 159b, 405, 406, 408, 409, 502), the first through-hole interconnect (169, 219) isolated from the third channel layer (209, 309) by insulating material (229, 420), the first through-hole interconnect (169, 219) electrically connecting logic circuits (103, 153) underneath the vertical NOR memory array.

**20.** The method of claim 15, further comprising:

forming at least a first conductive layer (191, 191a, 191b, 191c) and a second conductive layer (191, 191a, 191b, 191c), separated by a first dielectric layer (192a, 192b), underneath the first stack (102, 105, 152, 155, 190, 403a, 403b, 477a, 477b) and the second stack (102, 105, 152, 155, 190, 403a, 403b, 477a, 477b);

forming a first vertical opening (109a, 109b, 109c, 159a, 159b, 405, 406, 408, 409, 502) in the first stack (102, 105, 152, 155, 190, 403a, 403b, 477a, 477b) that extends at least up to the second conductive layer (191, 191a, 191b, 191c) and a second vertical opening (109a, 109b, 109c, 159a, 159b, 405, 406, 408, 409, 502) in the second stack (102, 105, 152, 155, 190, 403a, 403b, 477a, 477b) that extends at least up to the second conductive layer (191, 191a, 191b, 191c);

removing at least part of the first conductive layer (191, 191a, 191b, 191c) and the first dielectric layer (192a, 192b) through the first vertical opening (109a, 109b, 109c, 159a, 159b, 405, 406, 408, 409, 502) and the second vertical opening (109a, 109b, 109c, 159a, 159b, 405, 406, 408, 409, 502), thereby forming a first void (443, 464, 474, 483) under the first stack (102, 105, 152, 155, 190, 403a, 403b, 477a, 477b) and a second void (443, 464, 474, 483) under the second stack (102, 105, 152, 155, 190, 403a, 403b, 477a, 477b); and

forming a first conductive structure (143) in the first void (443, 464, 474, 483) and a second conductive structure (143) in the second void (443, 464, 474, 483),

wherein the first conductive structure (143) extends through at least a section (200, 200a, 300, 300a) of the first dielectric layer (192a, 192b), to interconnect the first conductive layer (191, 191a, 191b, 191c) and the second conductive layer (191, 191a, 191b, 191c).

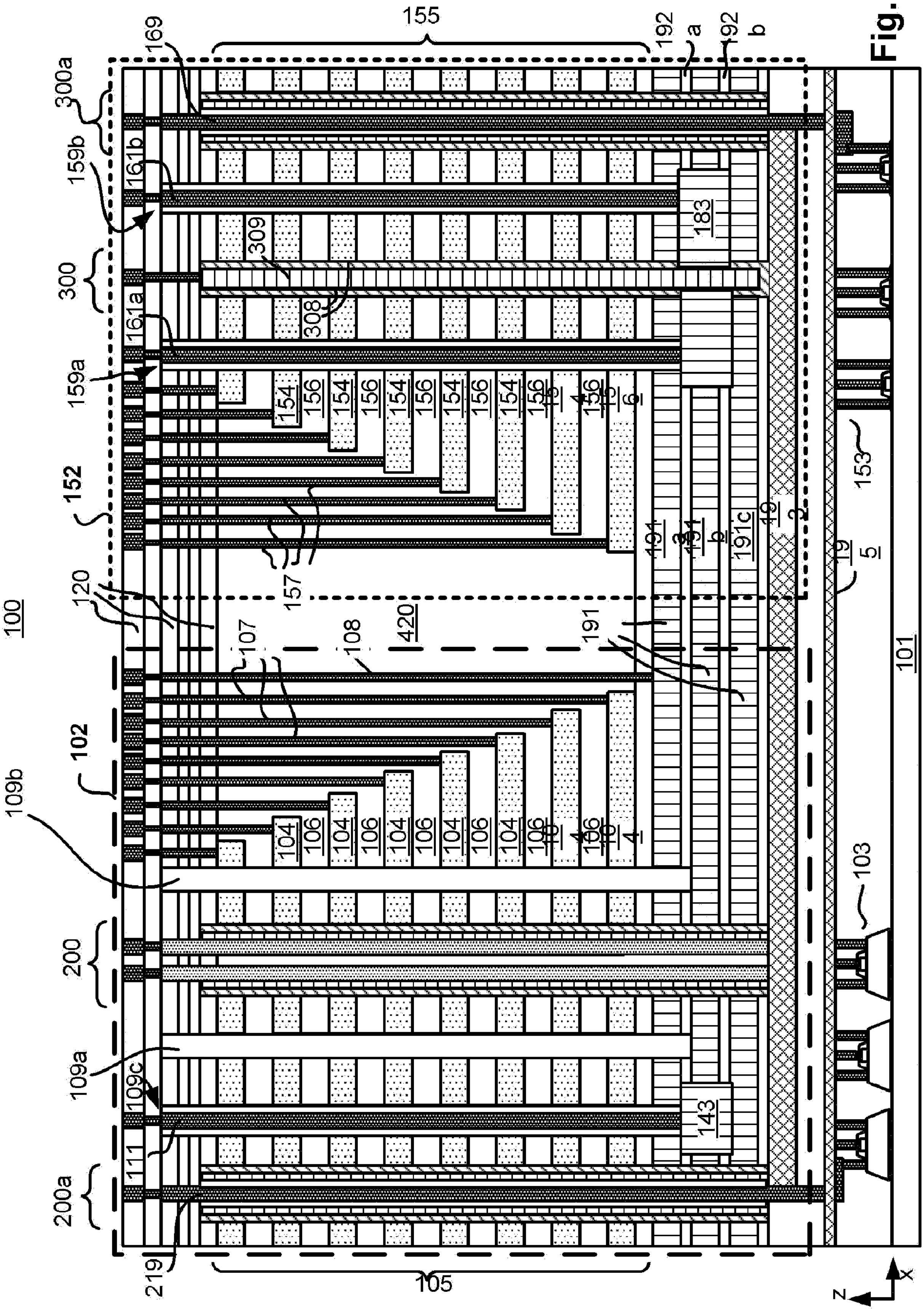
100
101
102
103
104
105
106
107
108
109a
109b
109c
111
120
143
152
153
154
155
156
157
159a
159b
161a
161b
169
183
191
192
a
192
b
200
200a
219
300
300a
308
309
420
z
x

Fig. 1

Fig. 2A

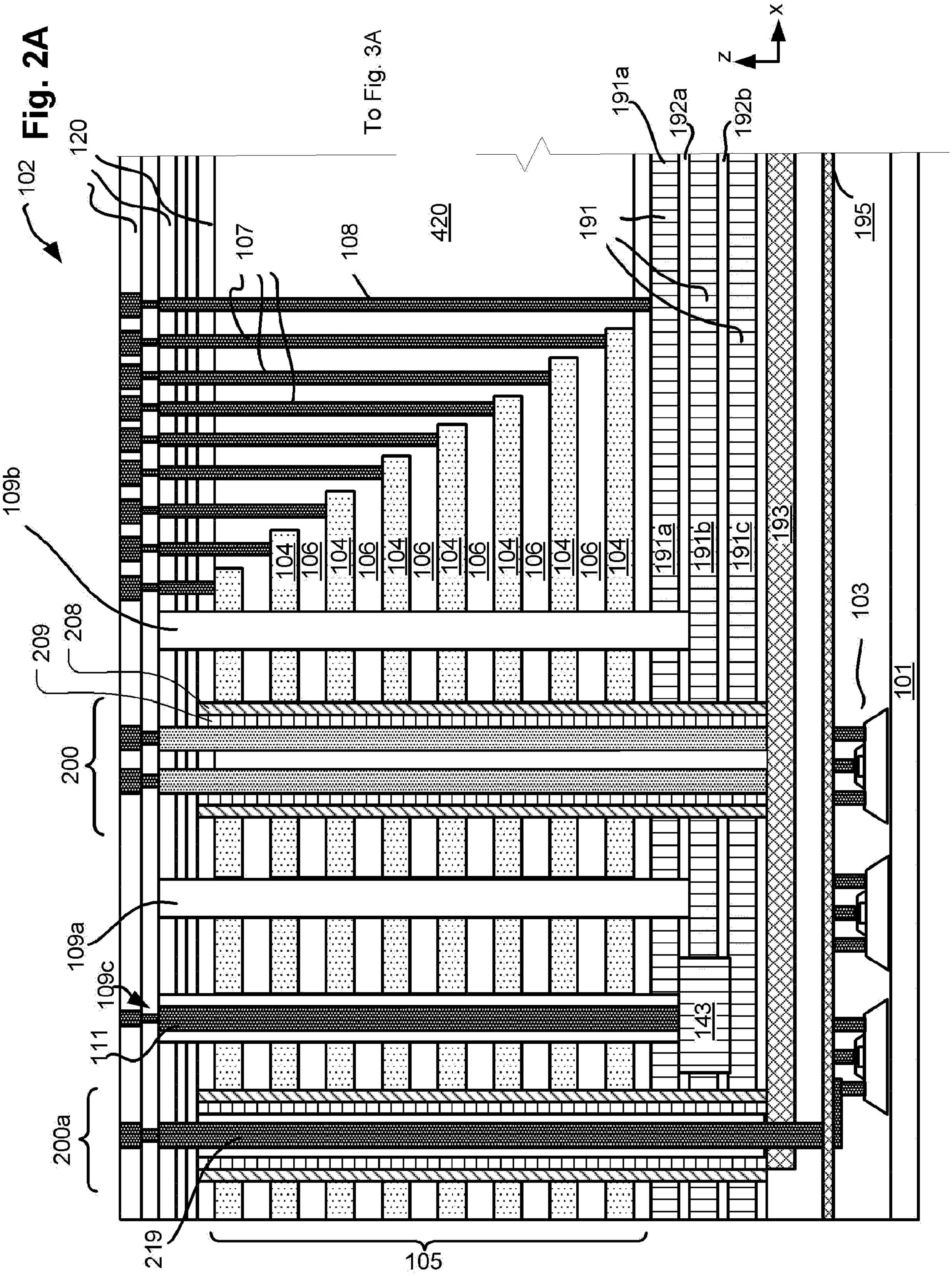
102
120
To Fig. 3A
z
x
191a
192a
192b
107
108
420
191
195
109b
104
106
191a
191b
191c
193
103
101
209
208
200
143
109a
109c
111
200a
219
105

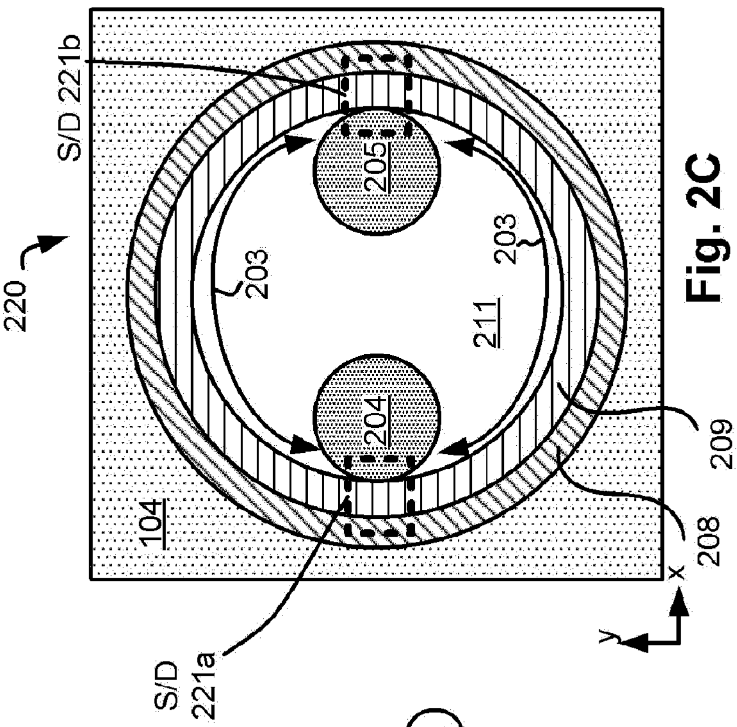


Fig. 2C

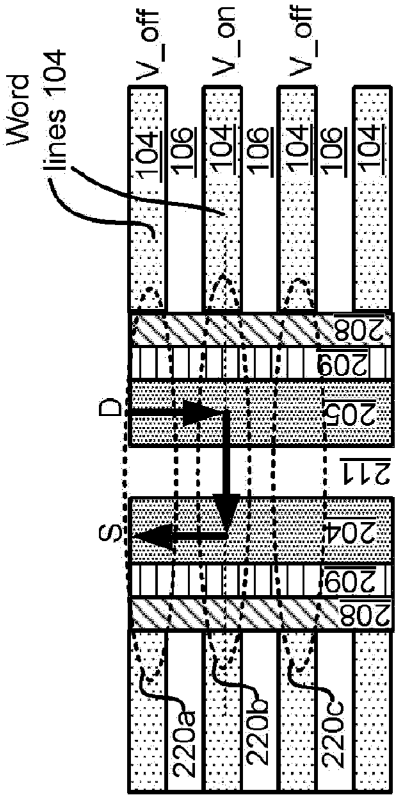


Fig. 2C1

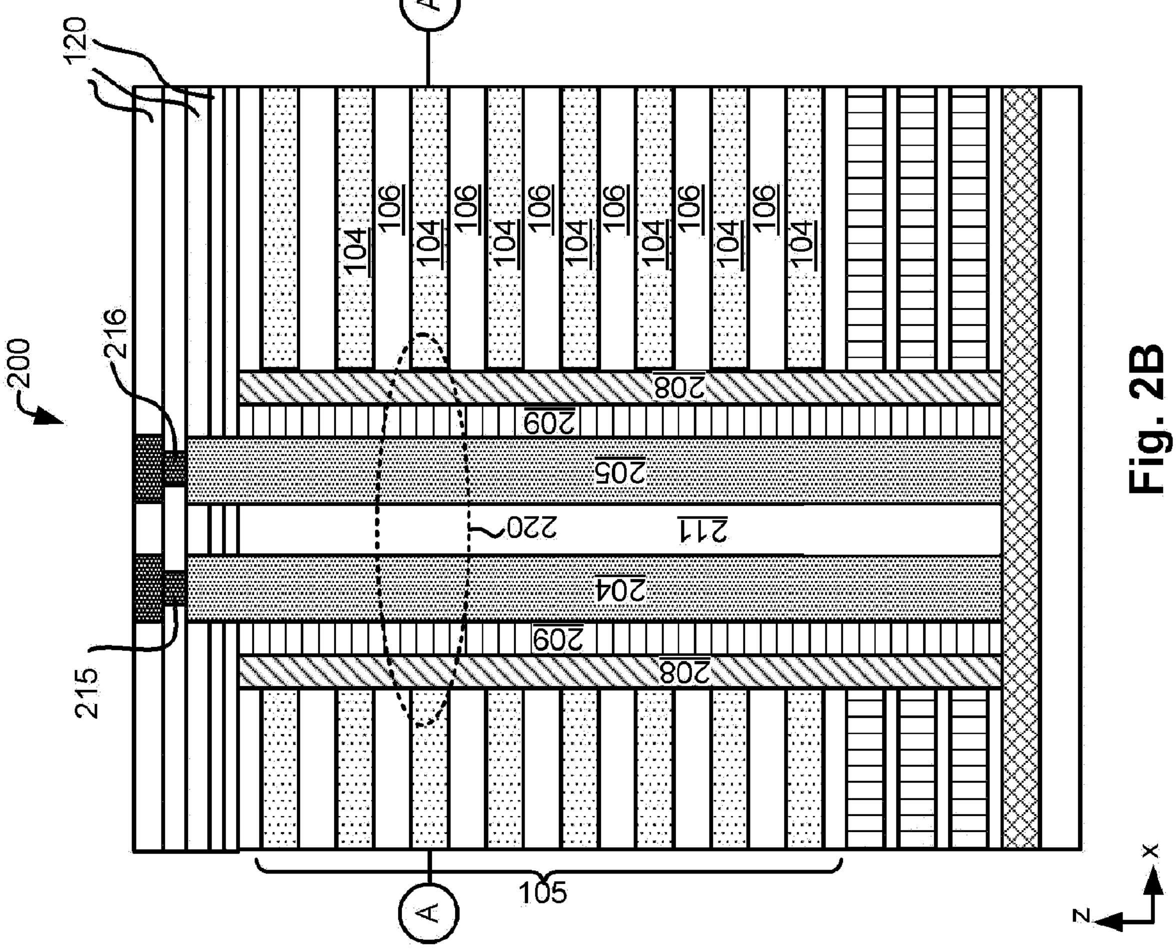


Fig. 2B

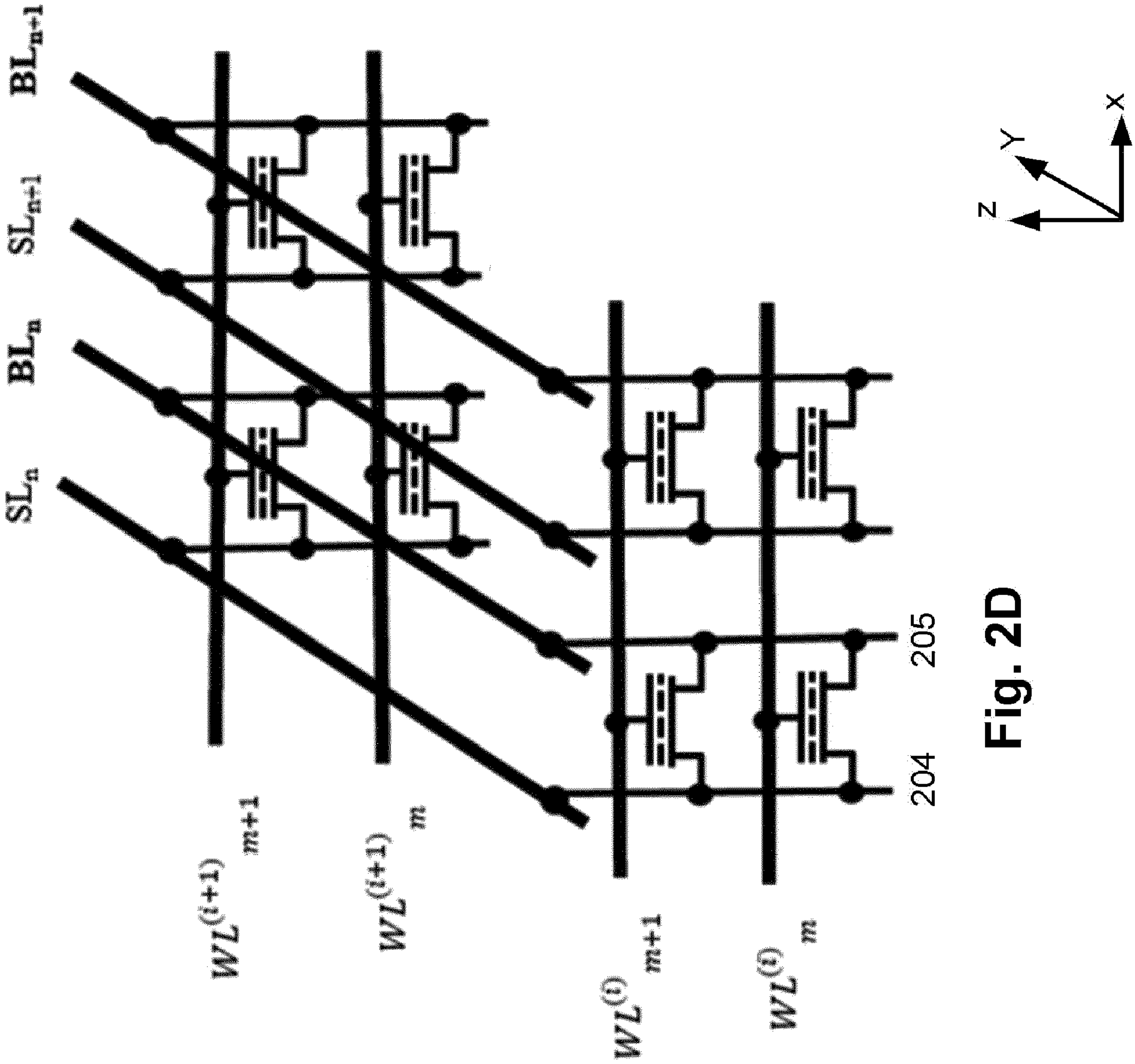


Fig. 2D

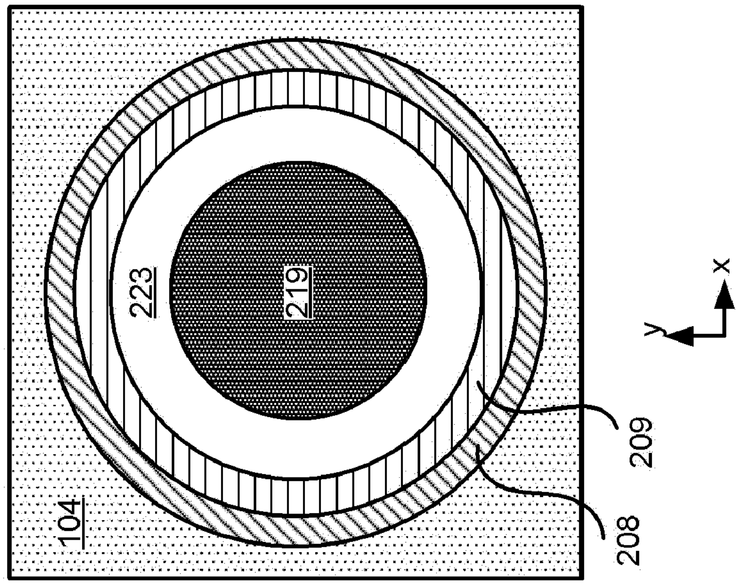

104
223
219
209
208
y
x


Fig. 2F

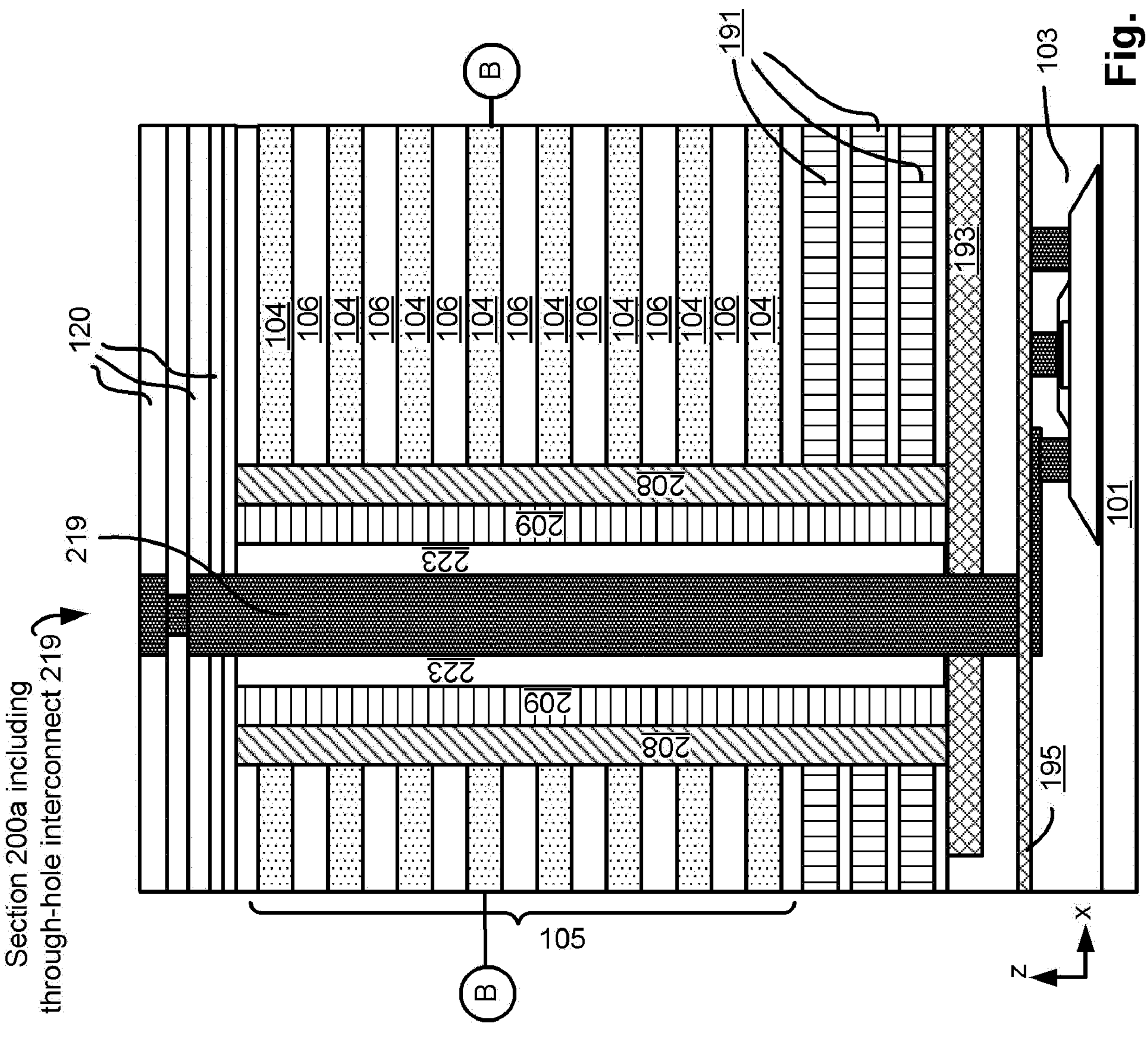

Section 200a including through-hole interconnect 219
219
120
B
B
104
106
191
193
208
209
223
105
103
101
195
z
x


Fig. 2E

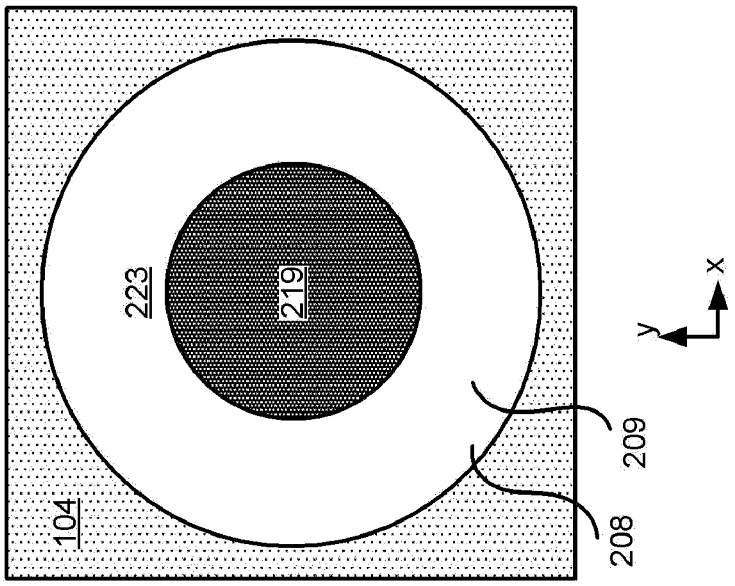


Fig. 2F1

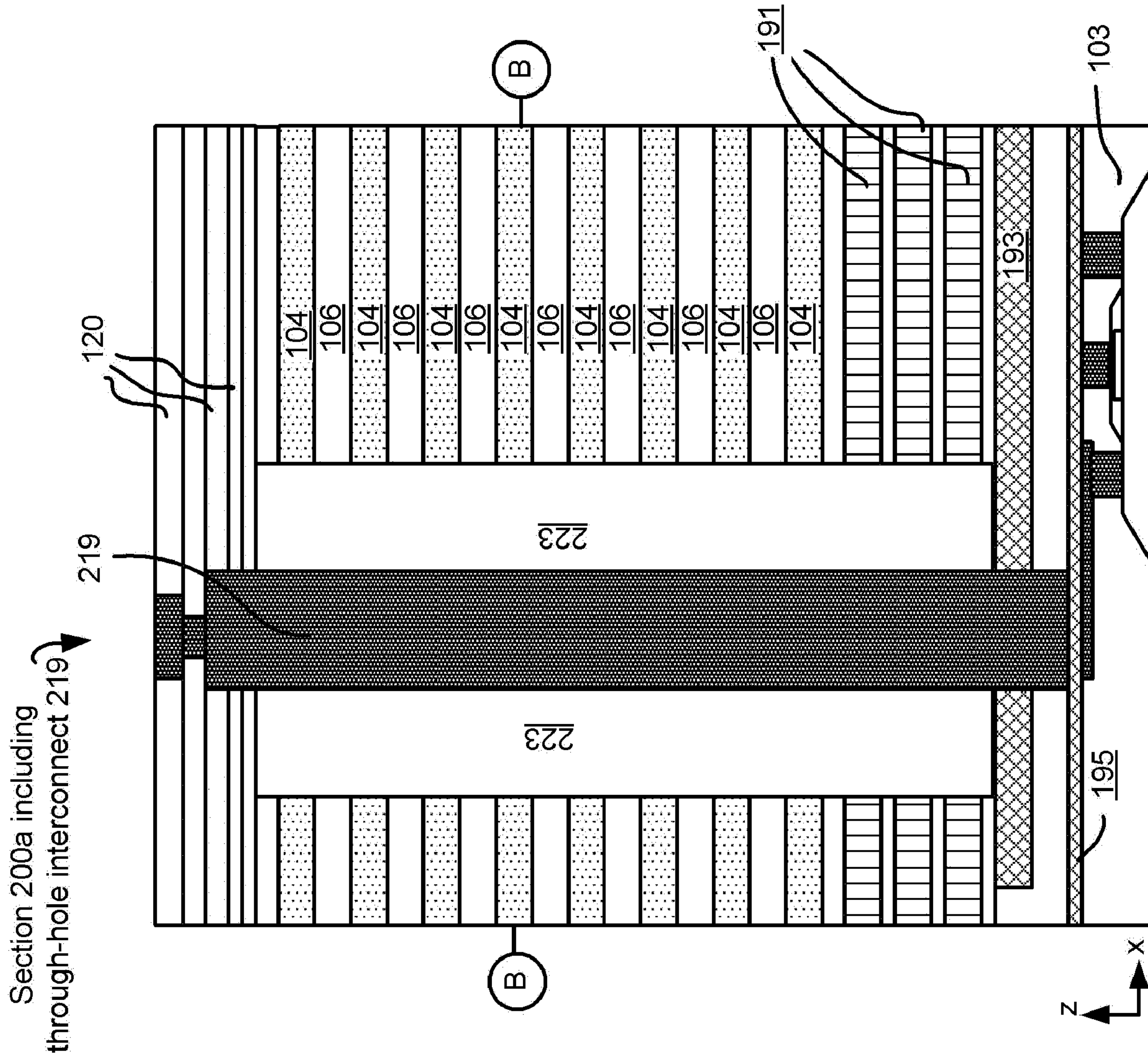


Fig. 2E1

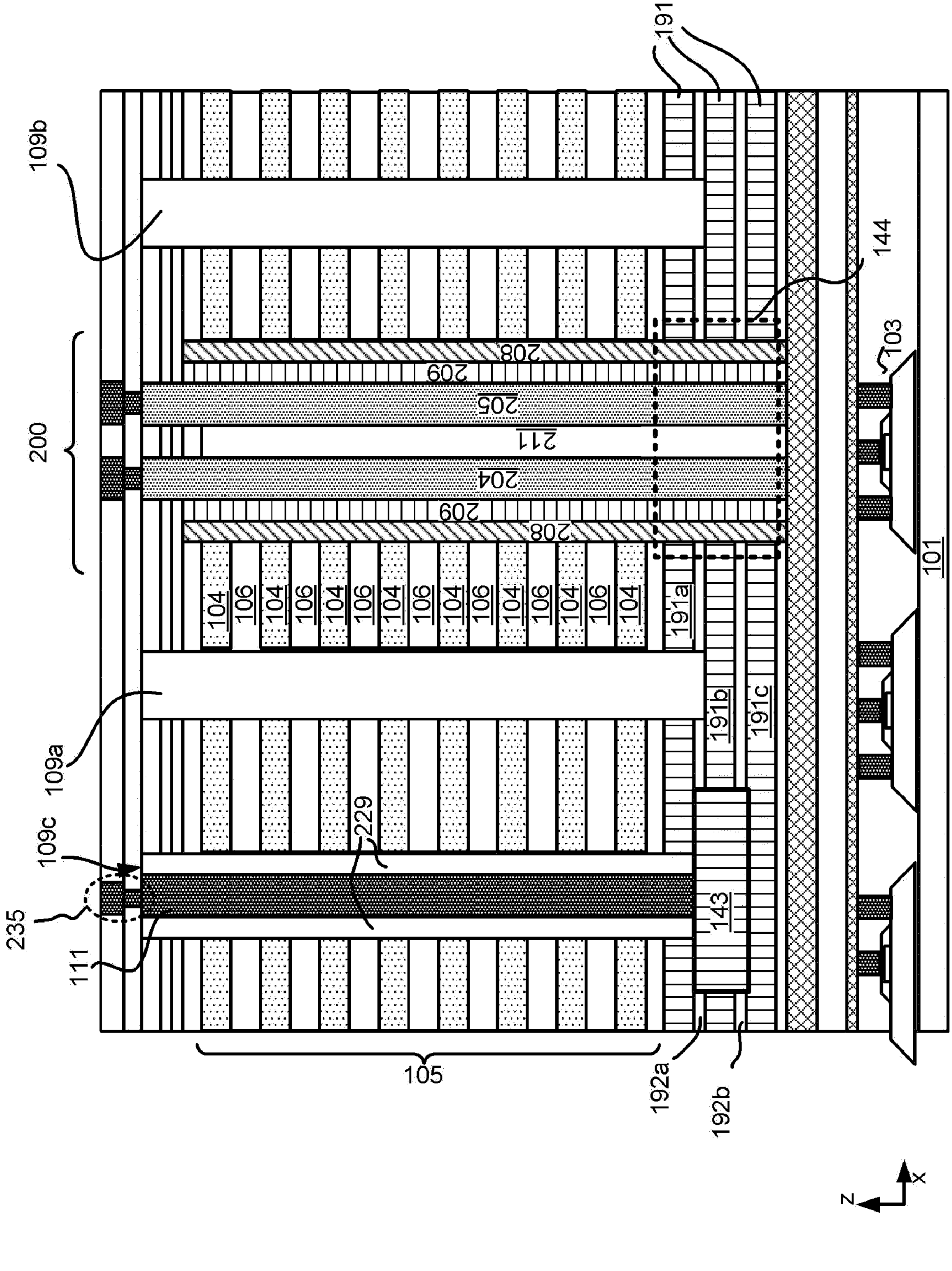
109b
200
109a
109c
235
111
229
105
192a
192b
191
191a
191b
191c
143
144
103
101
104
106
208
209
205
211
204
z
x

Fig. 2G

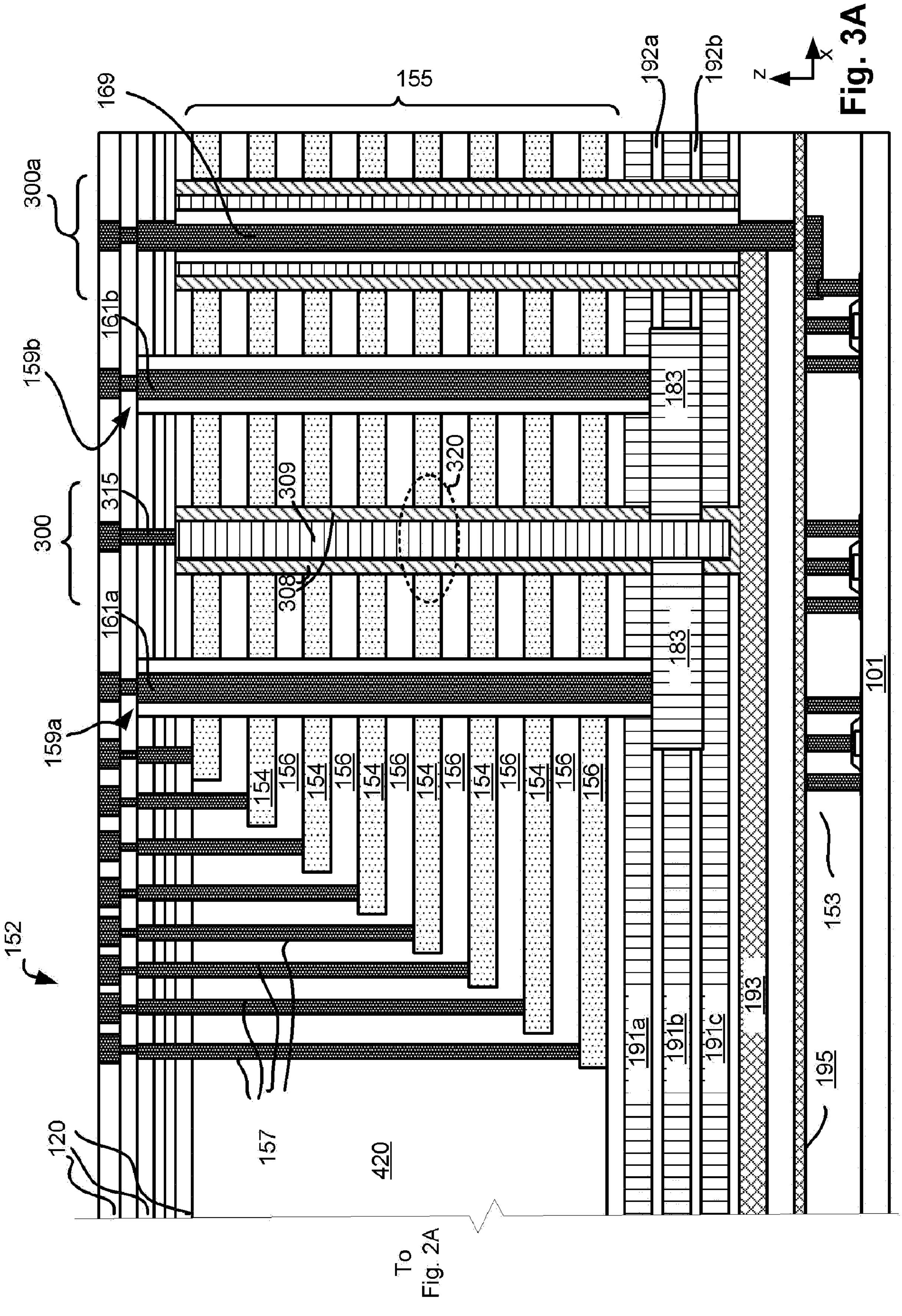
152
120
157
420
159a
161a
300
315
308
309
320
159b
161b
300a
169
155
154
156
183
191a
191b
191c
192a
192b
193
195
153
101
z
x
To Fig. 2A

Fig. 3A

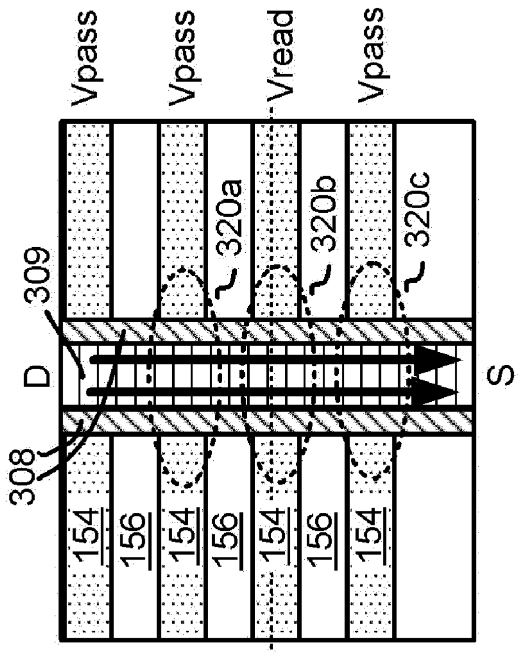
Vpass
Vpass
Vread
Vpass
309
308
D
S
320a
320b
320c
154
156
154
156
154
156
154

Fig. 3D

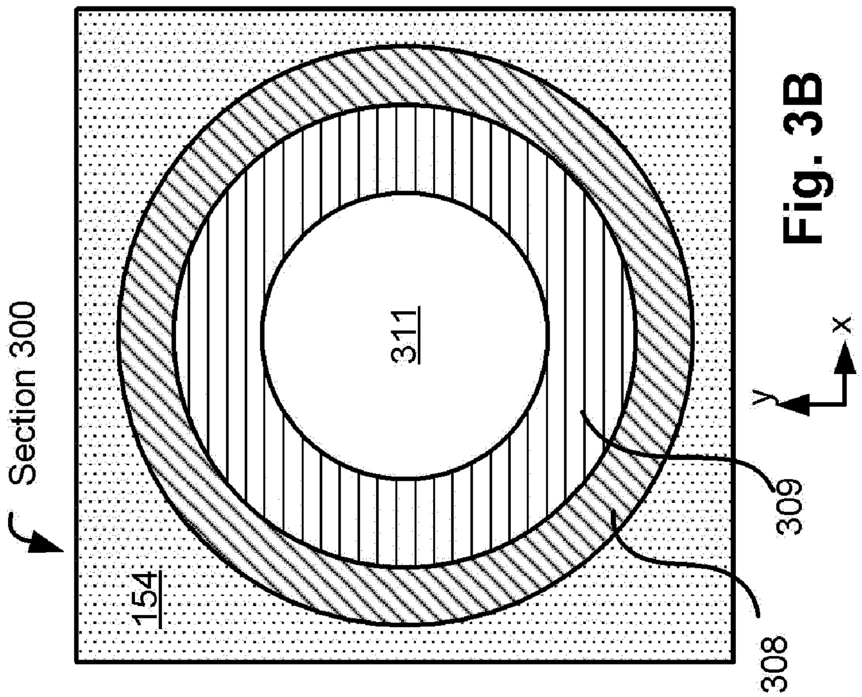
Section 300
154
311
309
308
y
x

Fig. 3B

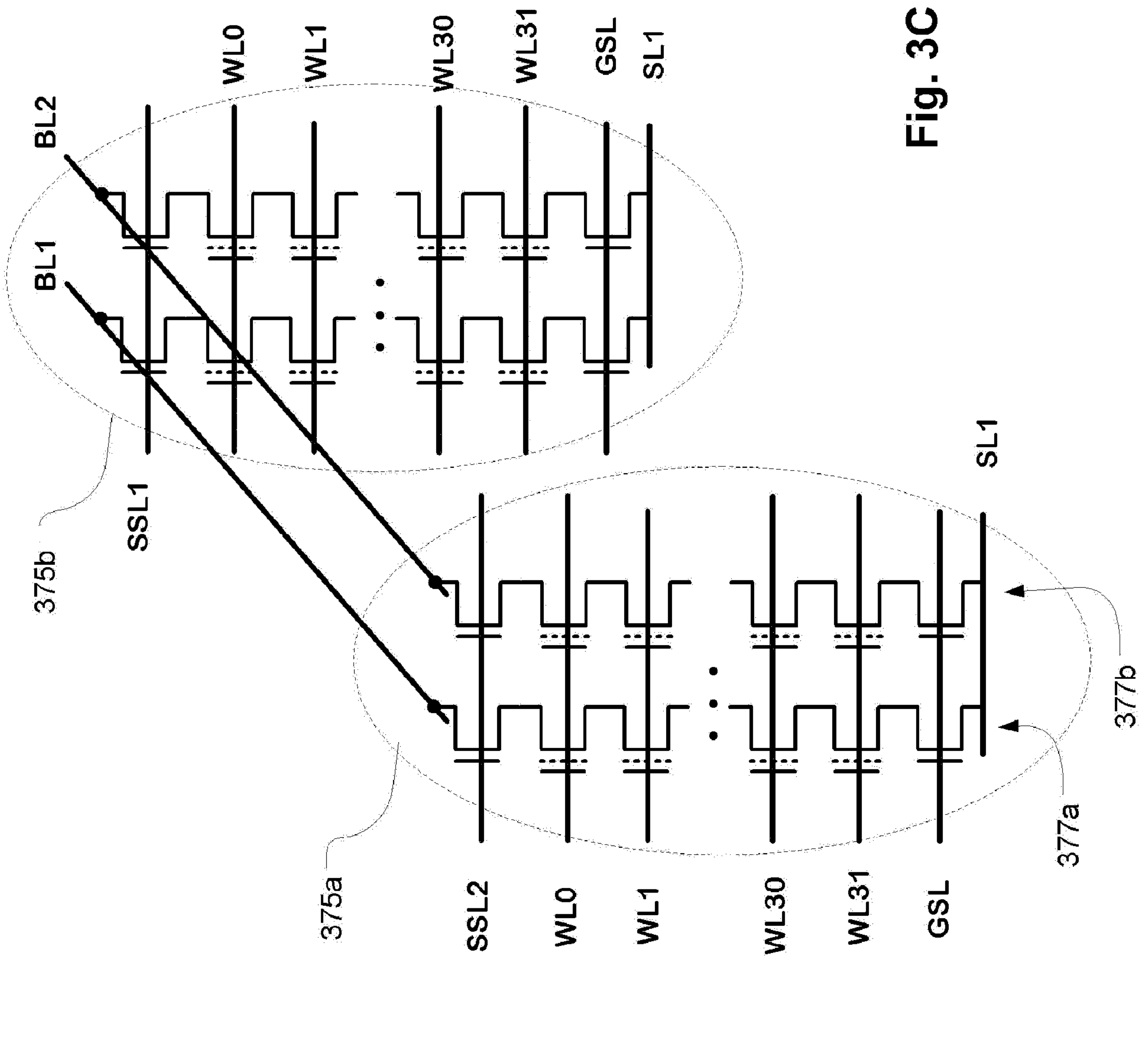
BL2
BL1
WL0
WL1
WL30
WL31
GSL
SL1
SSL1
375b
SL1
377b
377a
375a
SSL2
WL0
WL1
WL30
WL31
GSL

Fig. 3C

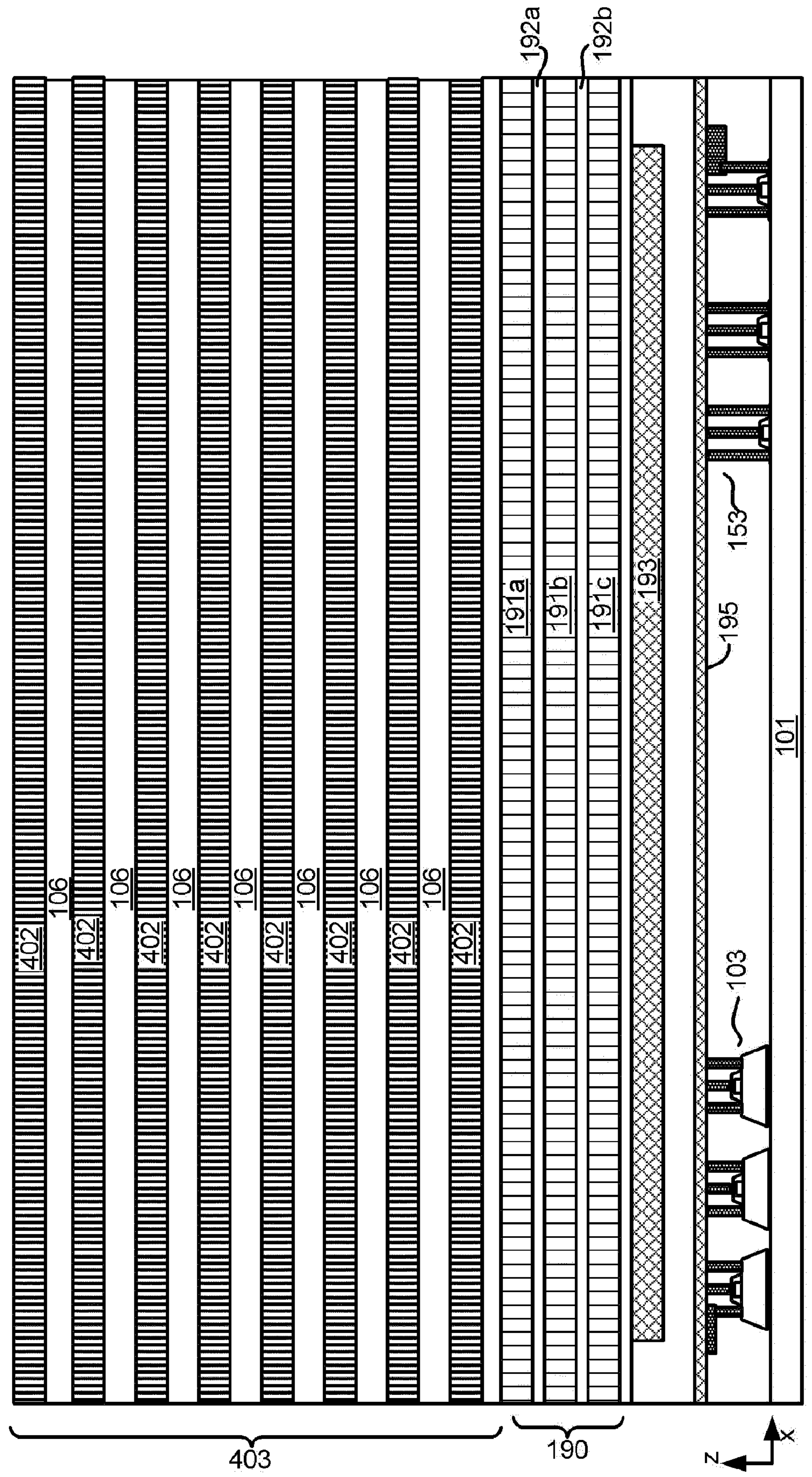


Fig. 4A

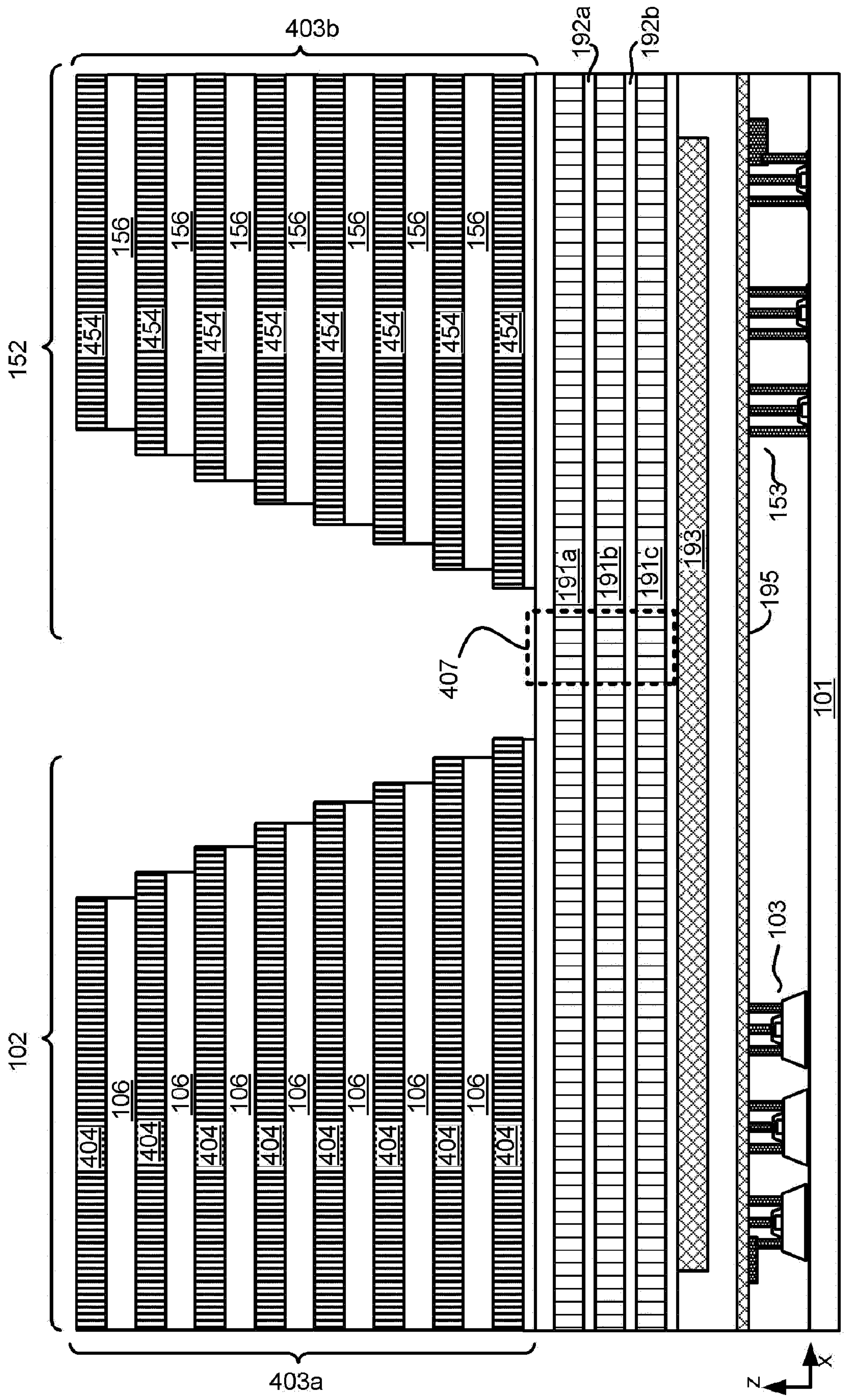
403b
152
102
403a
156
454
404
106
192a
192b
191a
191b
191c
193
195
153
103
101
407
z
x

Fig. 4B1

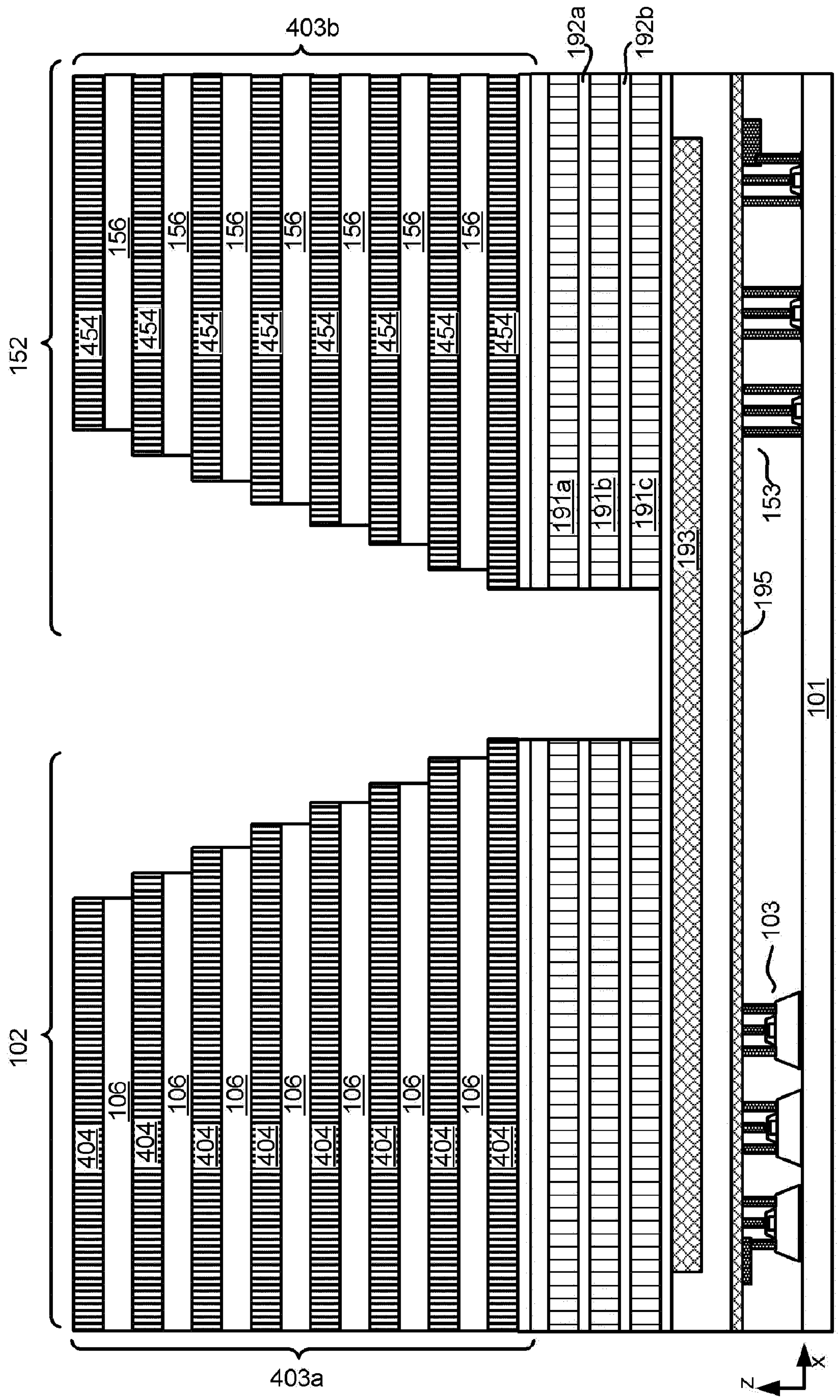

403b
192a
192b
152
454
156
191a
191b
191c
193
195
153
101
102
404
106
103
403a
z
x


Fig. 4B2

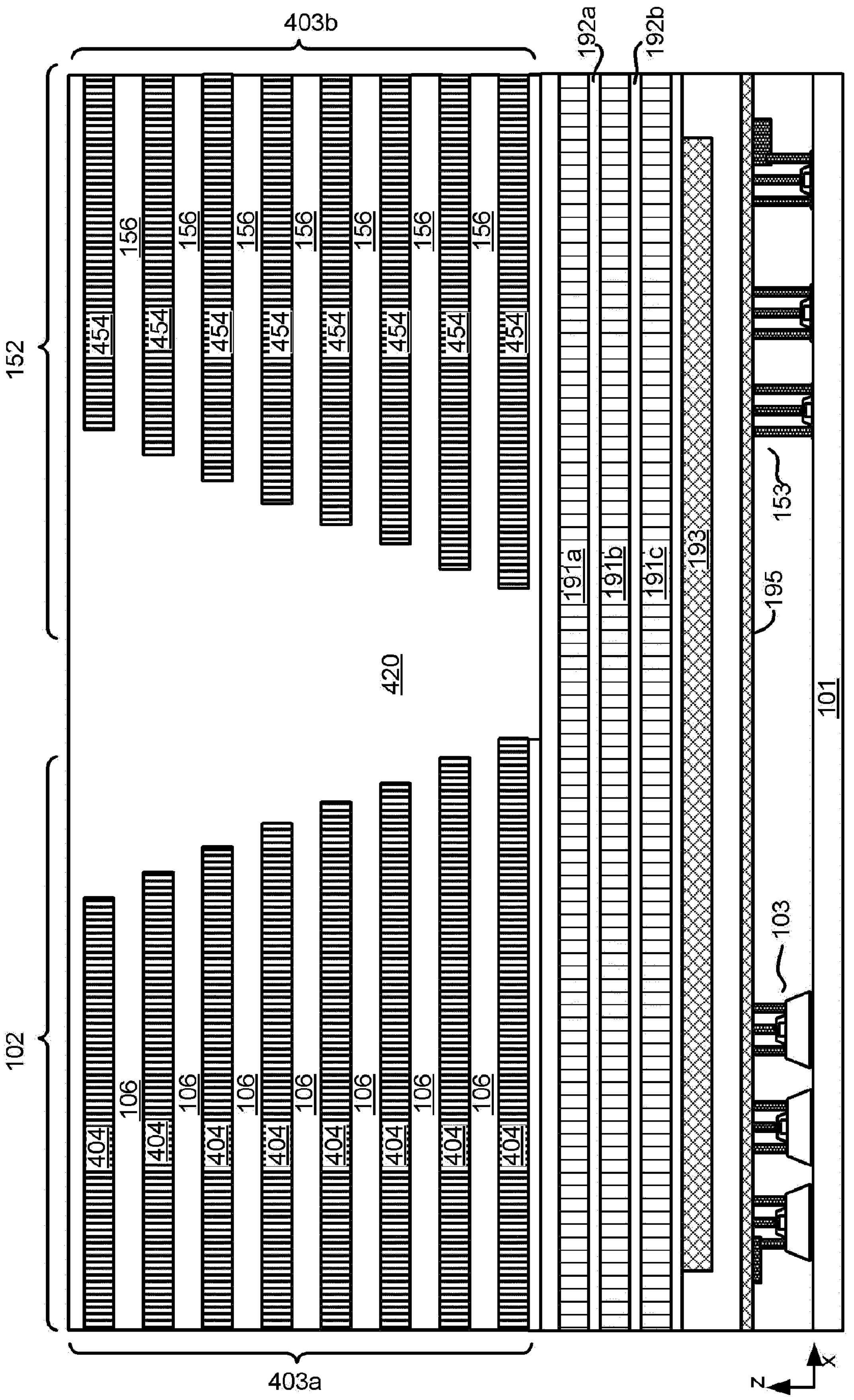
403b
152
102
403a
192a
192b
156
454
404
106
420
191a
191b
191c
193
153
195
103
101
Z
X

Fig. 4C

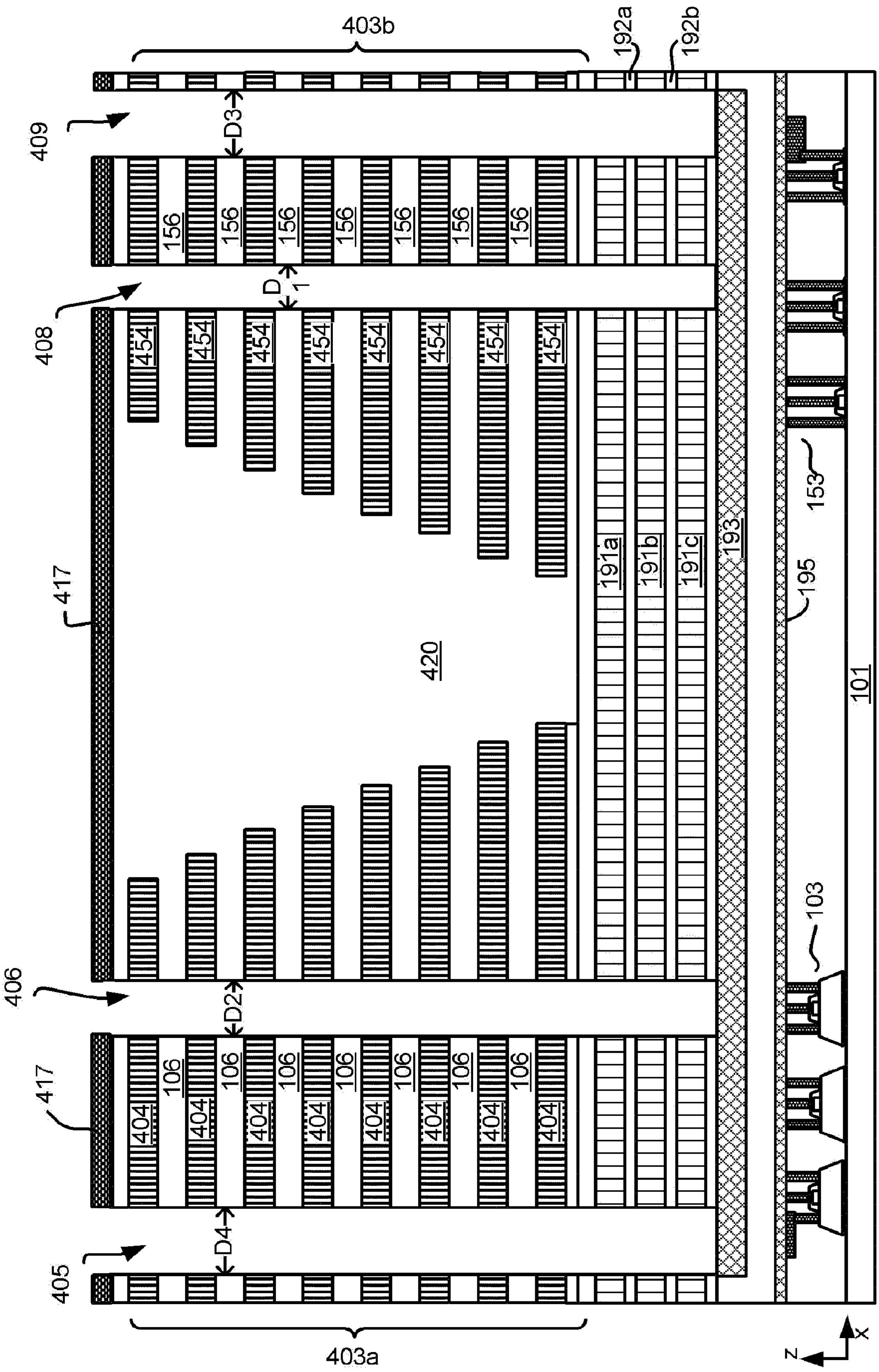
403b
192a
192b
409
D3
156
408
D
1
454
417
420
191a
191b
191c
193
153
195
101
103
406
D2
106
404
405
D4
403a
z
x

Fig. 4D

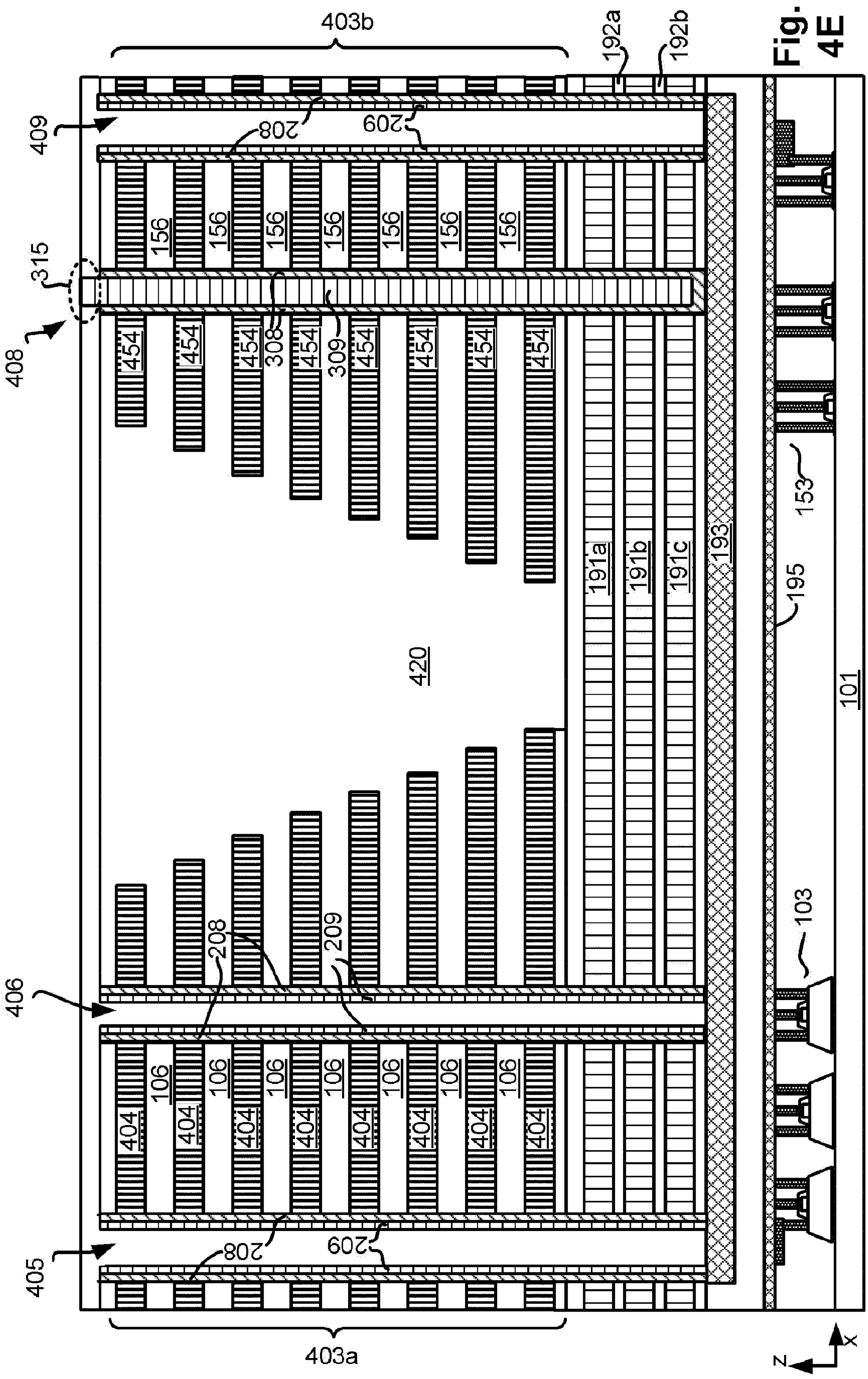
403b
192a
192b
409
208
209
315
408
156
454
308
309
191a
191b
191c
193
195
153
420
101
103
406
106
404
405
403a
z
x

Fig. 4E

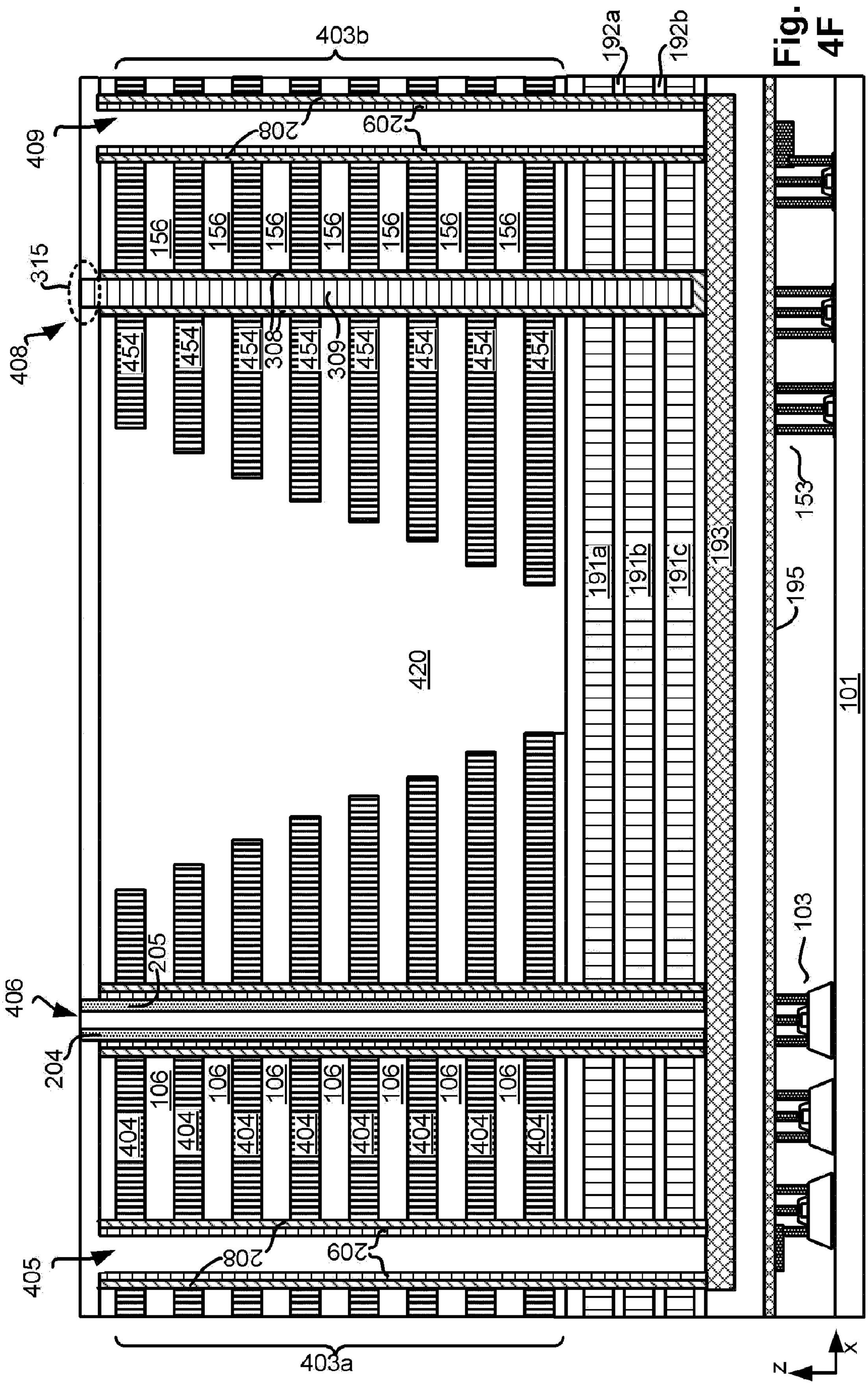
403b
192a
192b
409
208
209
156
315
408
454
308
309
191a
191b
191c
193
153
195
420
101
406
205
204
106
404
103
405
403a
z
x

Fig. 4F

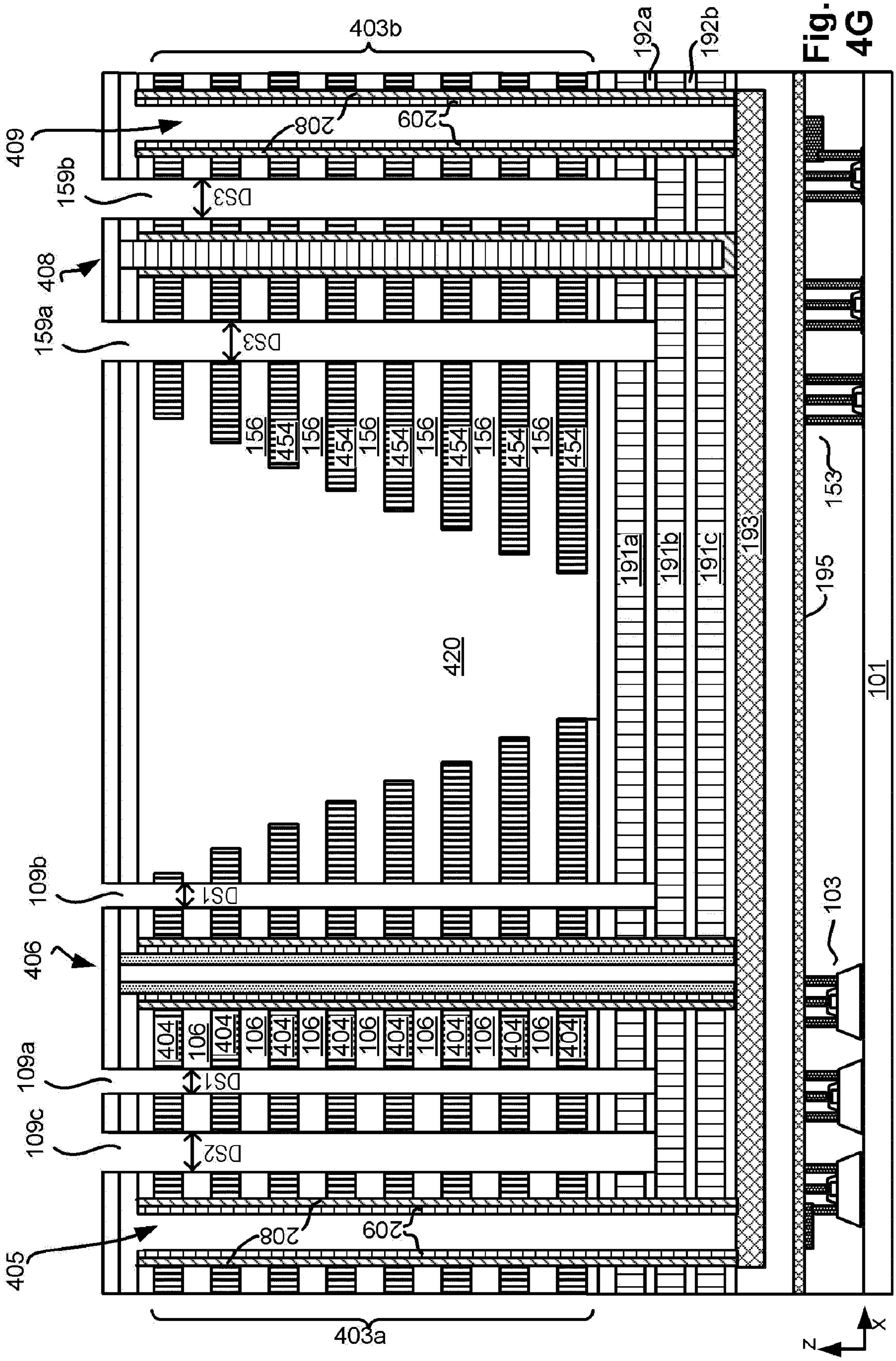
403b
192a
192b
409
208
209
159b
DS3
408
159a
DS3
156
454
420
191a
191b
191c
193
153
195
101
109b
DS1
406
103
404
106
109a
DS1
109c
DS2
405
208
209
403a
z
x

Fig. 4G

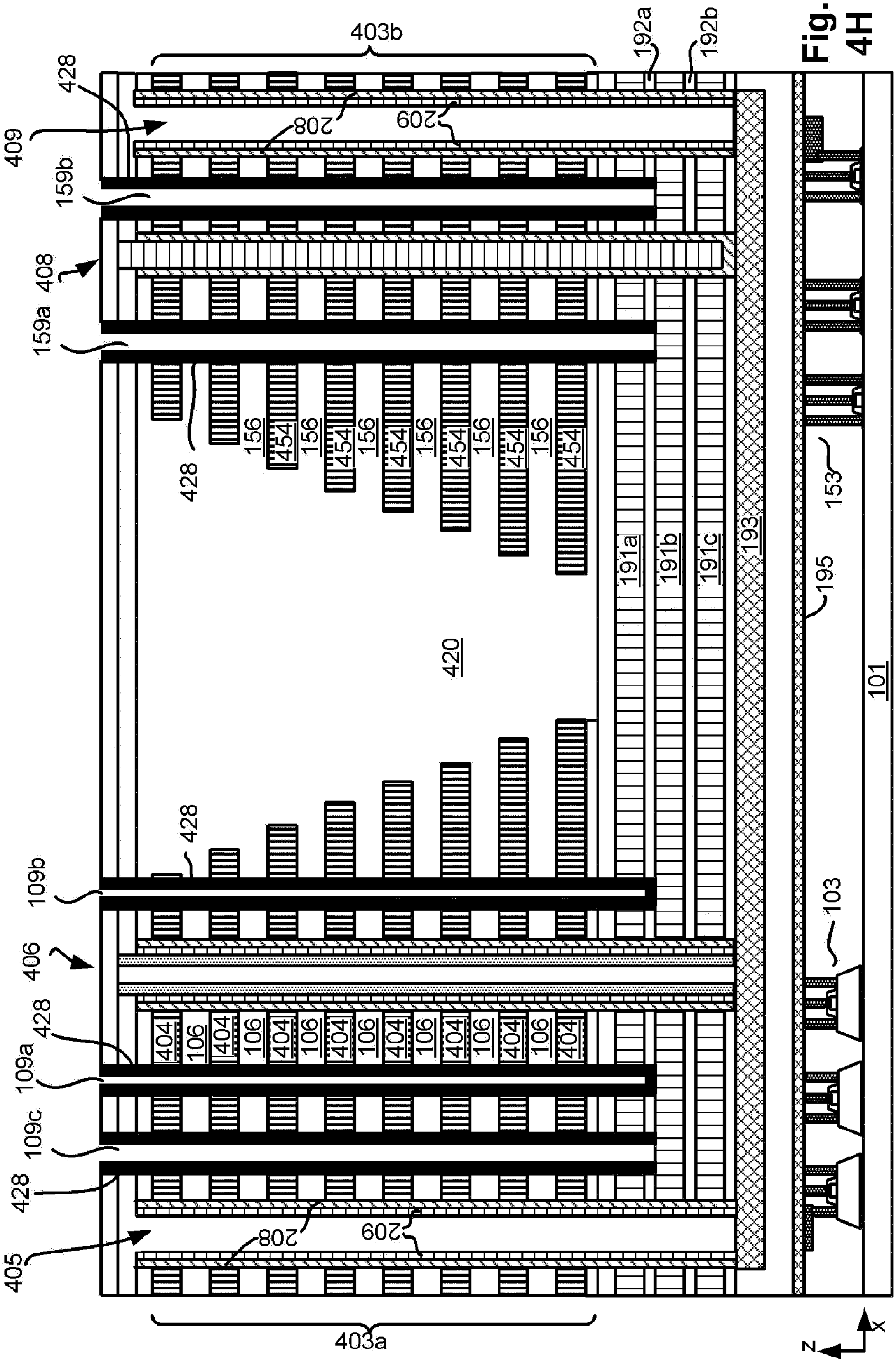
403b
192a
192b
428
409
208
209
159b
408
159a
156
454
428
191a
191b
191c
193
153
195
420
101
428
109b
406
103
404
106
109a
109c
405
403a
z
x

Fig. 4H

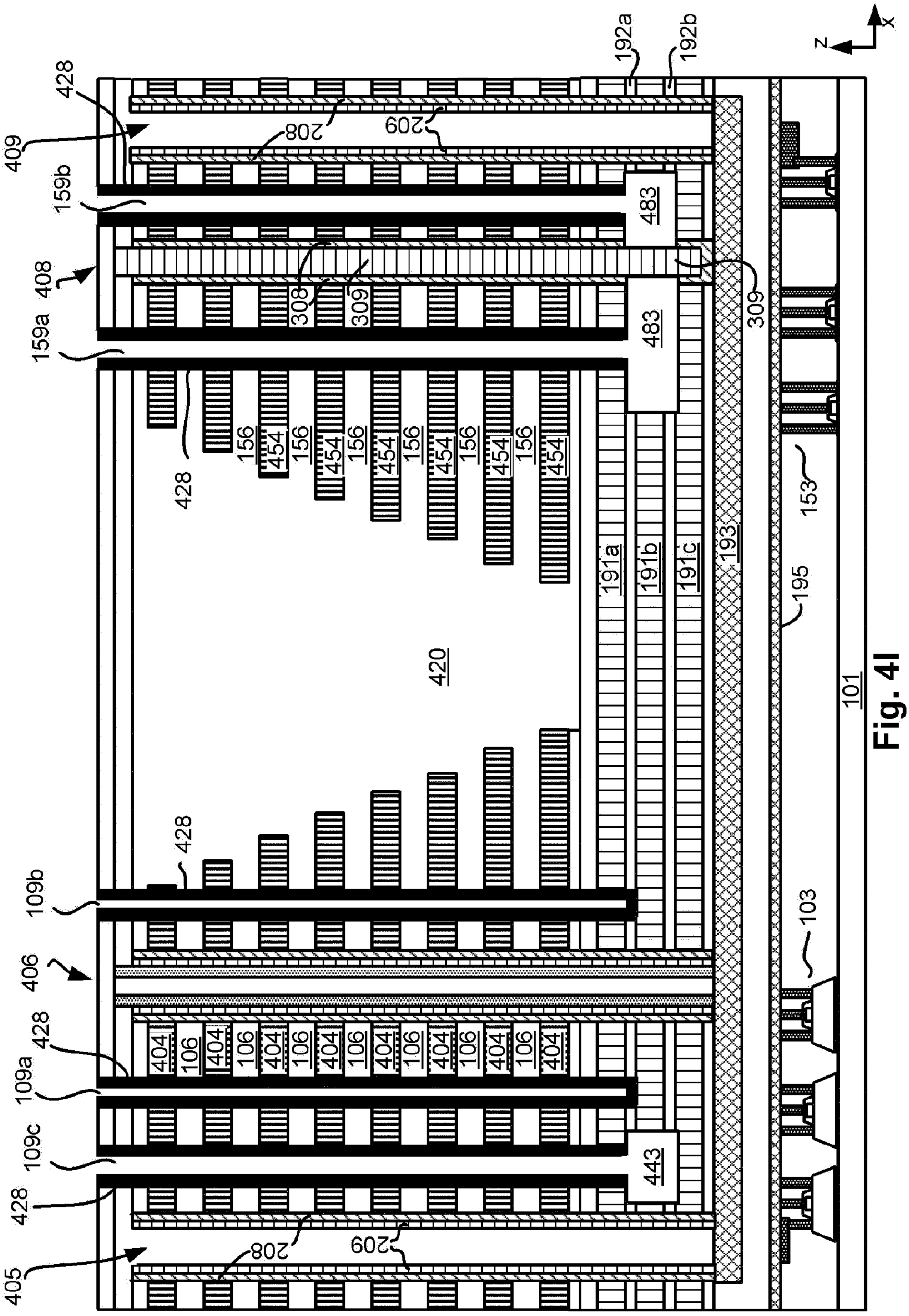

405
428
109c
109a
428
406
109b
428
159a
408
159b
409
428
208
209
443
404
106
420
156
454
191a
191b
191c
193
483
308
309
192a
192b
195
153
103
101
z
x


Fig. 4I

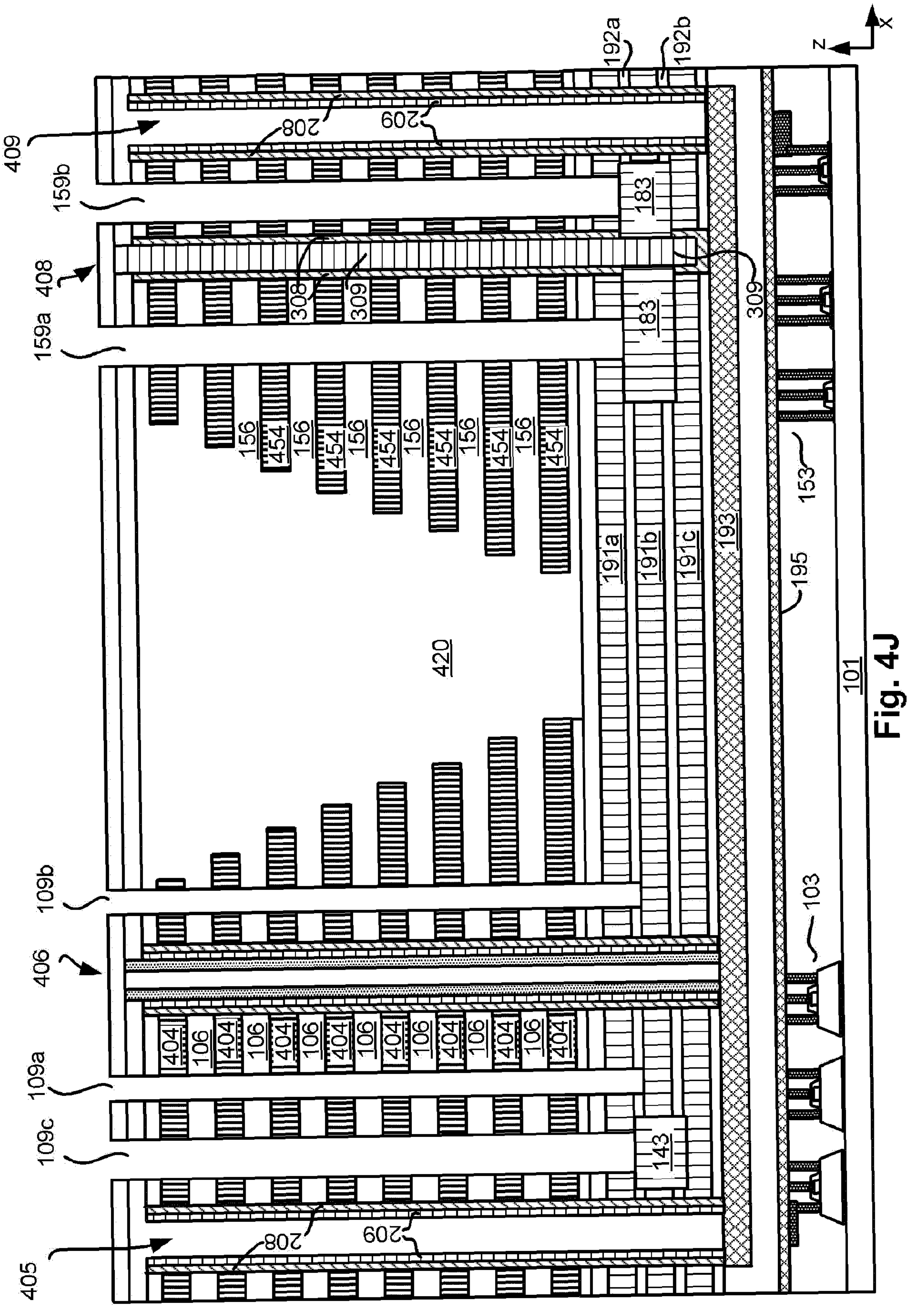

405
208
209
109c
143
109a
404
106
406
109b
420
156
454
191a
191b
191c
193
195
153
101
103
159a
408
308
309
183
159b
409
192a
192b
z
x


Fig. 4J

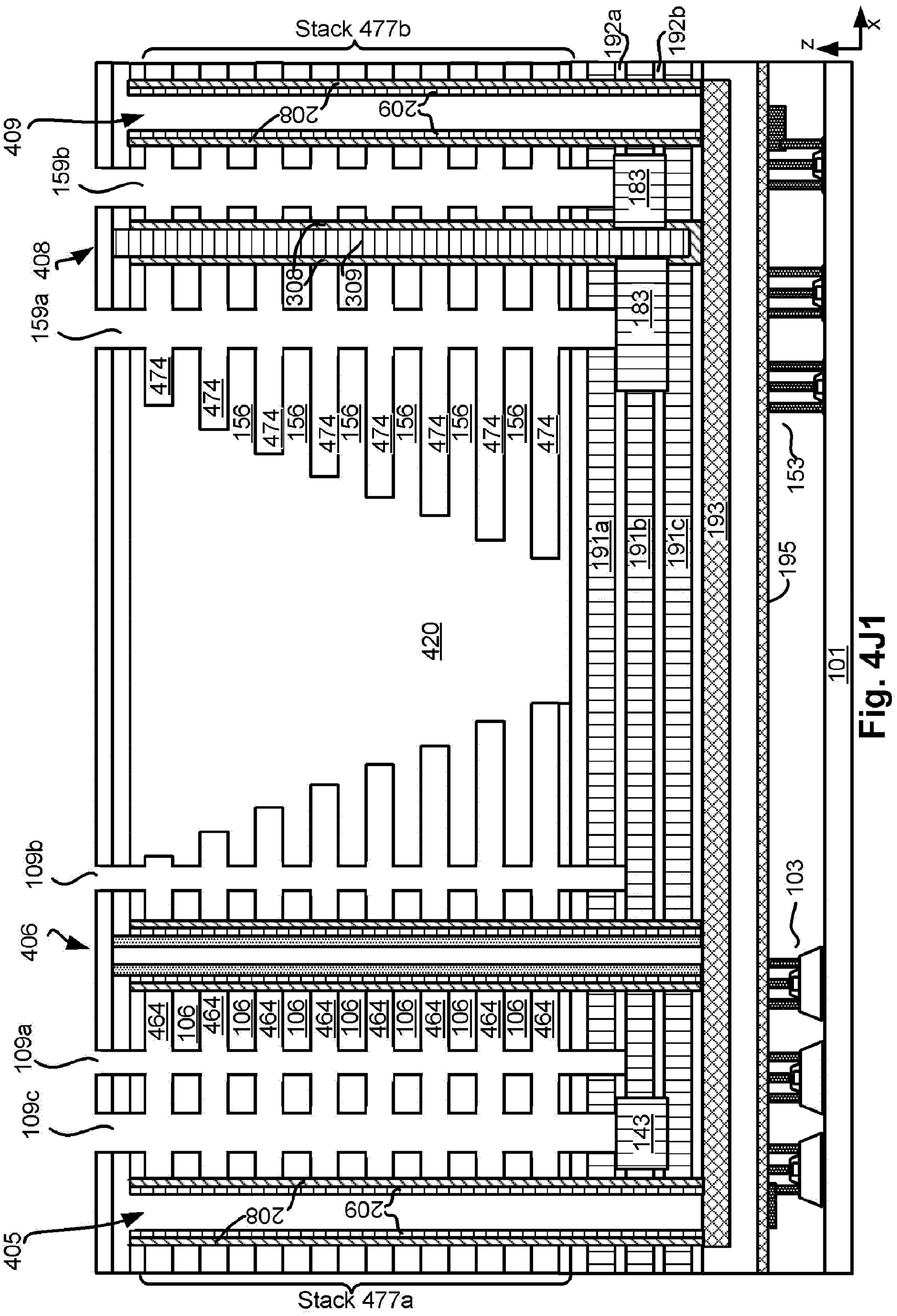
Stack 477b
192a
192b
z
x
409
208
209
159b
183
408
308
309
159a
474
156
420
191a
191b
191c
193
153
195
101
109b
103
406
464
106
109a
109c
143
405
Stack 477a

Fig. 4J1

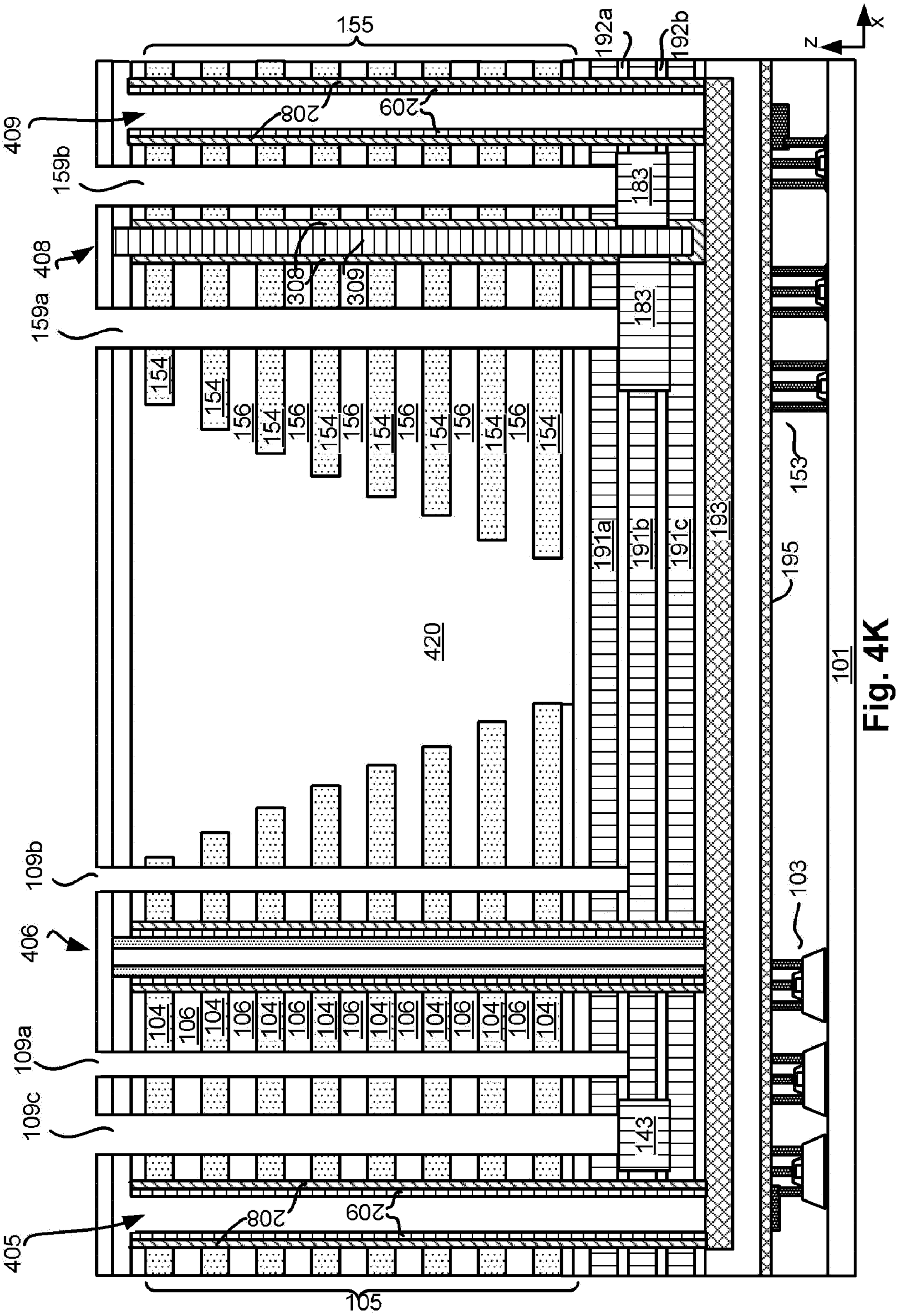
155
192a
192b
x
z
409
159b
408
159a
109b
406
109a
109c
405
105
208
209
308
309
183
143
154
156
104
106
420
191a
191b
191c
193
195
153
103
101

Fig. 4K

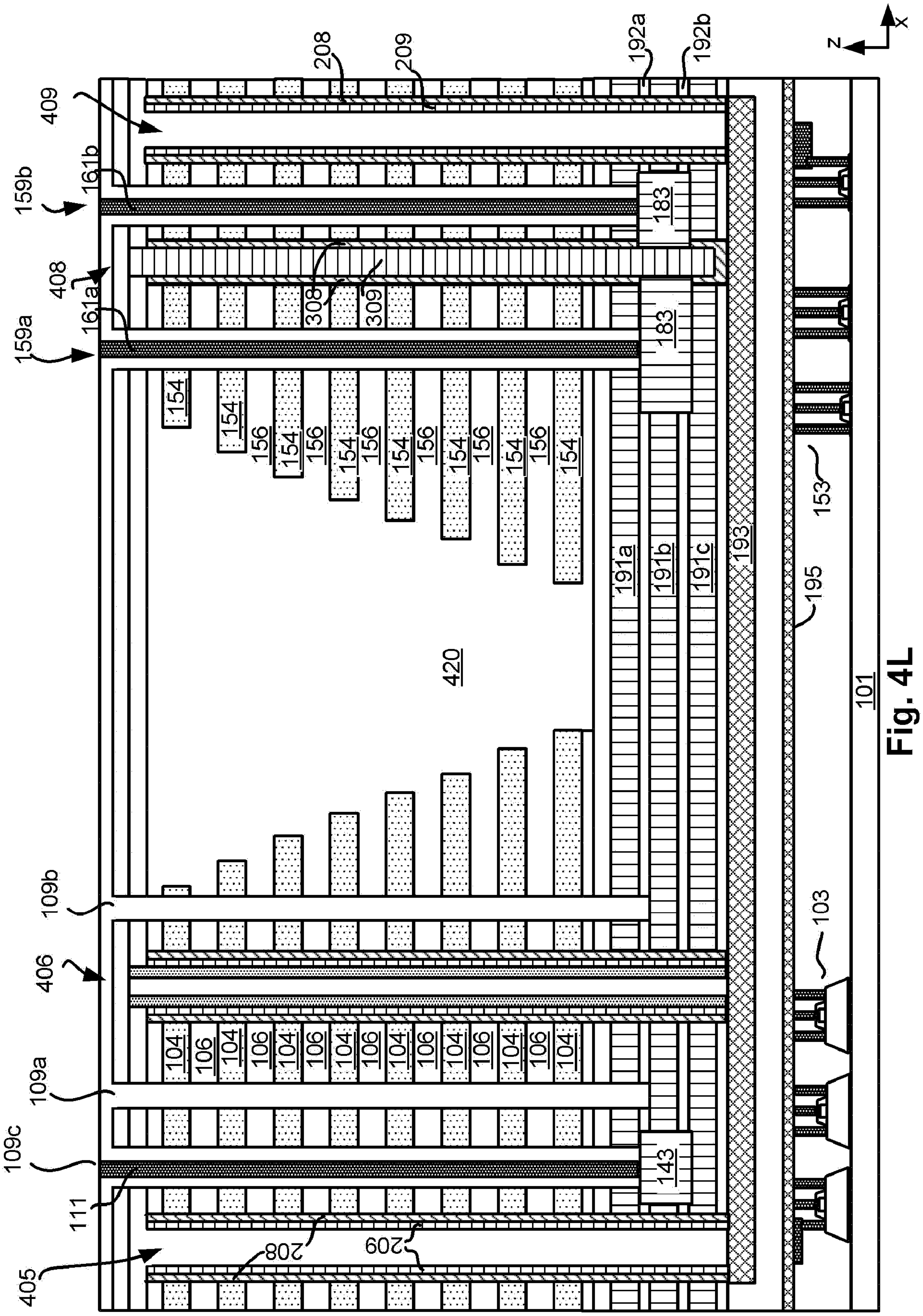

x
z
208
209
192a
192b
409
159b
161b
183
408
308
309
159a
161a
154
156
153
191a
191b
191c
193
195
420
101
109b
103
406
104
106
109a
109c
143
111
405


Fig. 4L

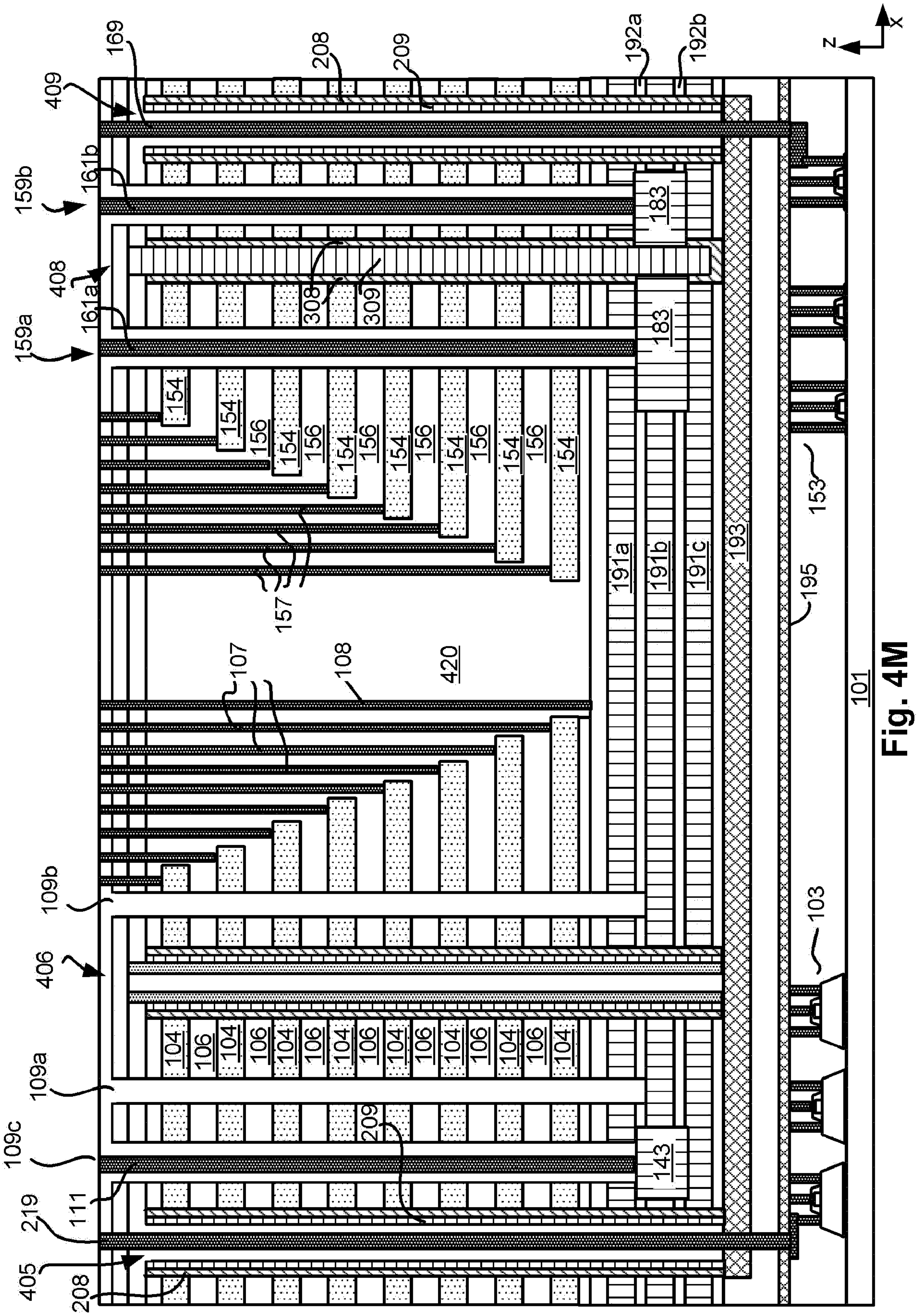
169
208
209
192a
192b
z
x
409
159b
161b
183
408
161a
308
309
159a
154
156
157
191a
191b
191c
193
195
153
107
108
420
101
109b
103
406
104
106
109a
143
109c
111
219
405

Fig. 4M

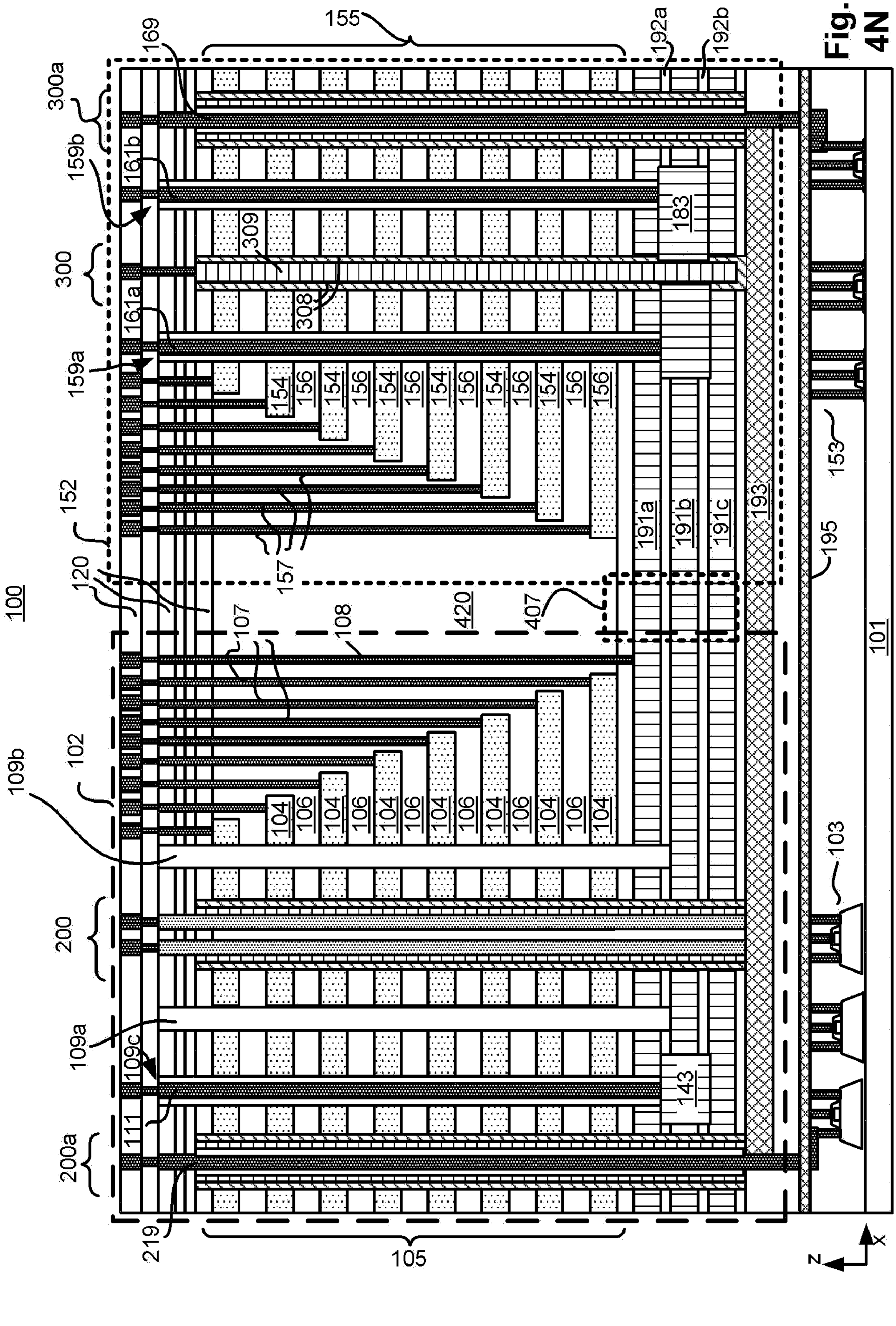
100
155
169
300a
159b
161b
192a
192b
183
309
300
308
161a
159a
154
156
152
157
191a
191b
191c
193
153
195
120
107
108
420
407
101
109b
102
104
106
200
103
109a
109c
143
111
200a
219
105
z
x

Fig. 4N

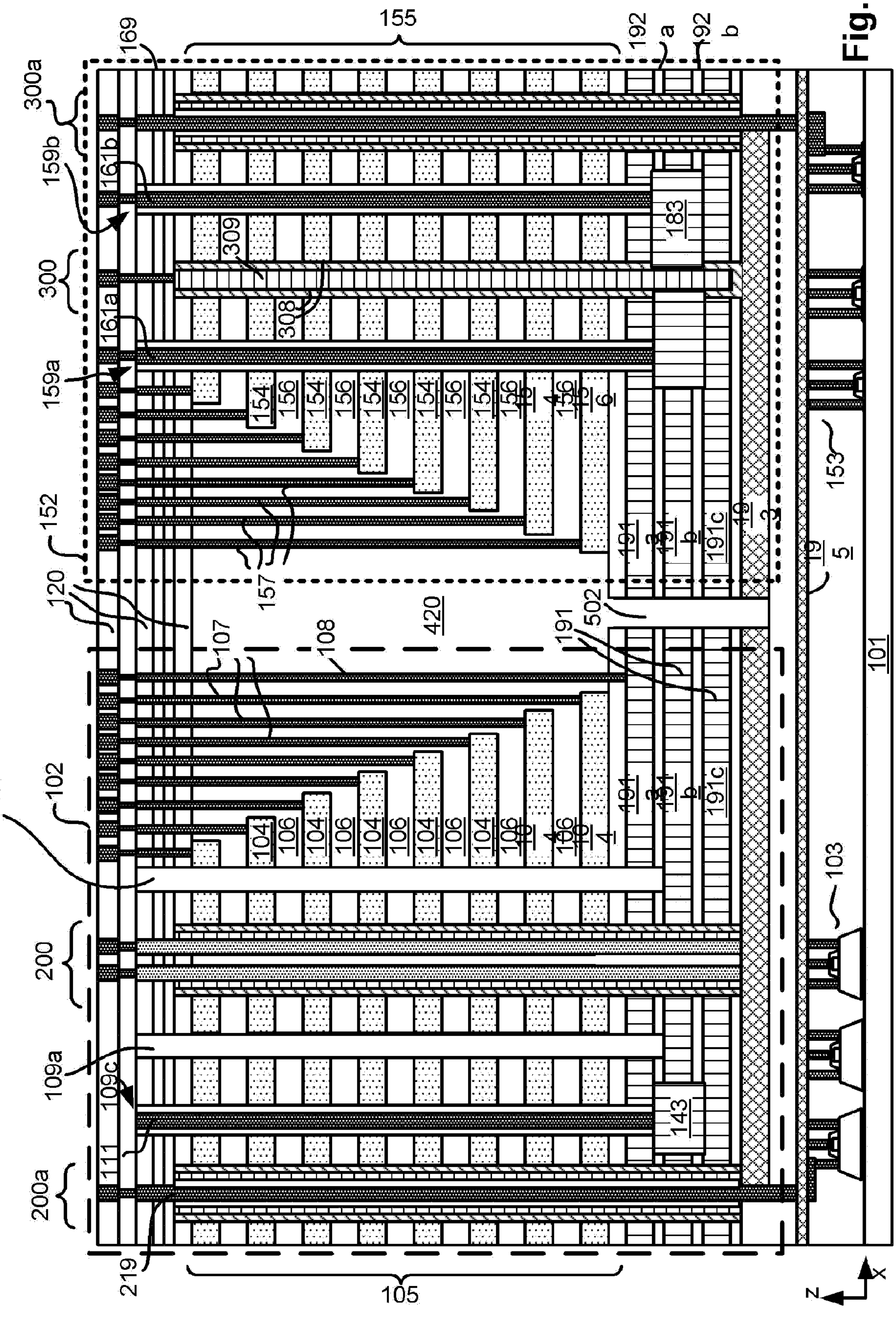
100
155
105
300a
159b
161b
300
161a
159a
152
120
200
109b
102
109a
109c
111
200a
219
169
192
a
b
183
309
308
154
156
157
107
108
420
502
191
191c
104
106
143
153
103
101
z
x

Fig. 5

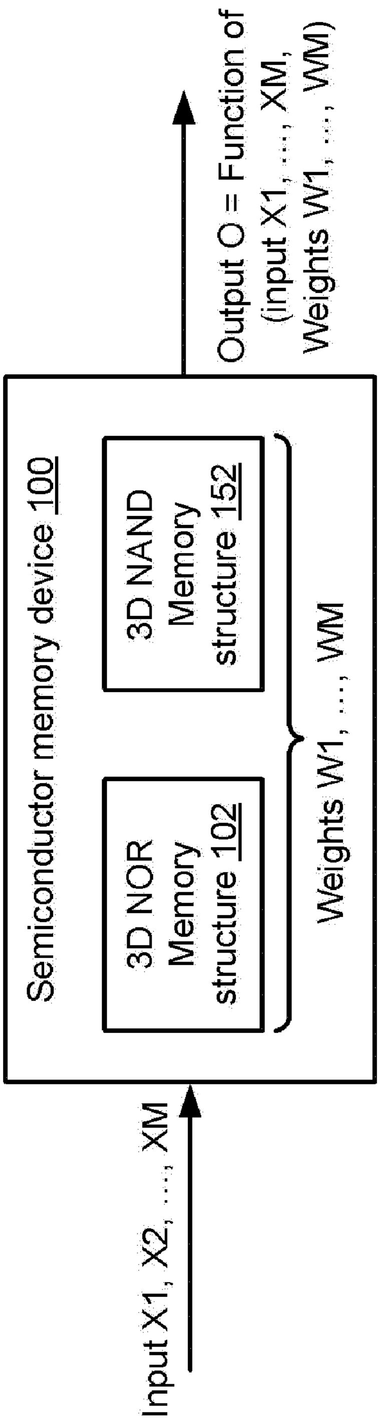
Semiconductor memory device 100
3D NOR Memory structure 102
3D NAND Memory structure 152
Weights W1, ..., WM
Input X1, X2, ..., XM
Output O = Function of (input X1, ..., XM, Weights W1, ..., WM)

Fig. 6A

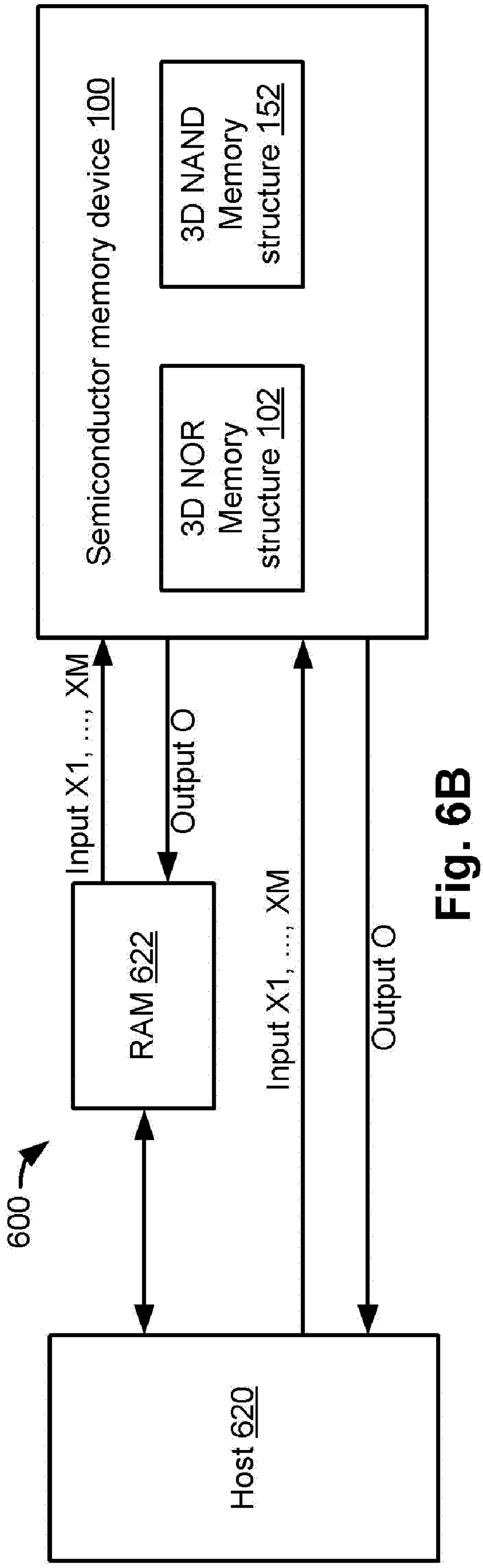
Semiconductor memory device 100
3D NOR Memory structure 102
3D NAND Memory structure 152
Input X1, ..., XM
Output O
RAM 622
Input X1, ..., XM
Output O
600
Host 620

Fig. 6B

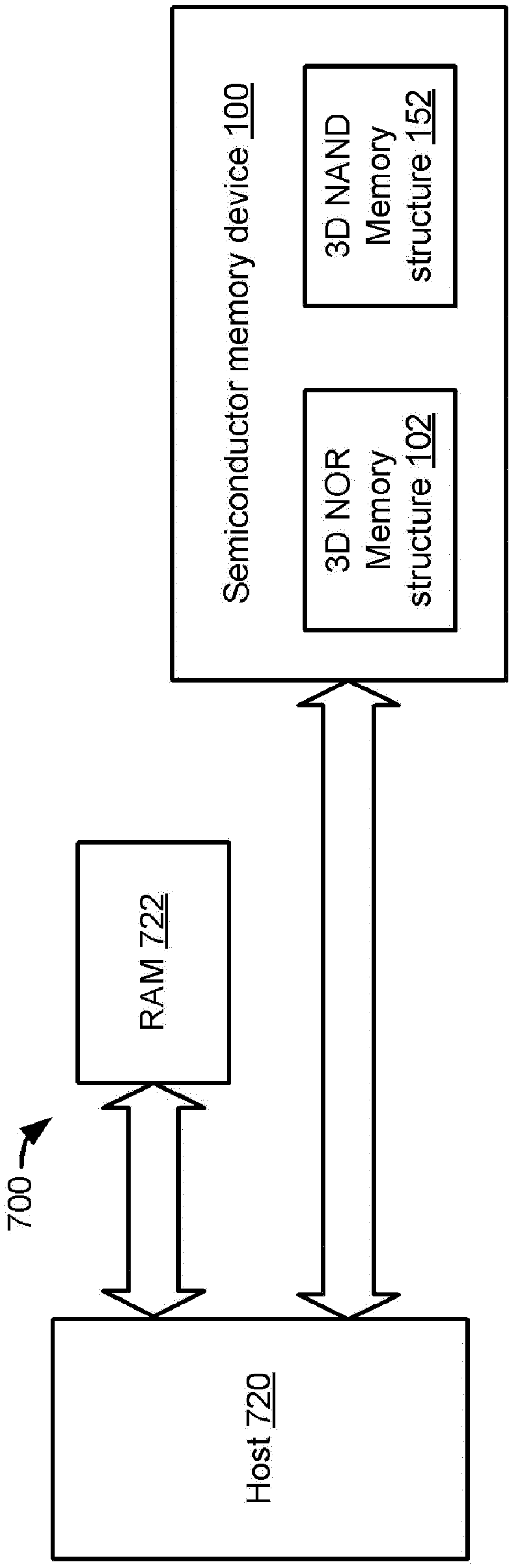
Semiconductor memory device 100
3D NAND Memory structure 152
3D NOR Memory structure 102
RAM 722
700
Host 720

Fig. 7

Europäisches Patentamt
European Patent Office
Office européen des brevets

## PARTIAL EUROPEAN SEARCH REPORT

under Rule 62a and/or 63 of the European Patent Convention. This report shall be considered, for the purposes of subsequent proceedings, as the European search report

Application Number
EP 22 16 0965

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | US 11 069 410 B1 (CUI ZHIXIN [JP] ET AL) 20 July 2021 (2021-07-20)<br>* the whole document *<br>----- | 1-4,7,8, 11,15-19<br>5,6,9,20<br>10 | INV.<br>H01L27/1157<br>H01L27/11582<br>G11C11/00 |
| Y | US 10 923 196 B1 (RABKIN PETER [US] ET AL) 16 February 2021 (2021-02-16)<br>* column 9, line 12 - line 27 *<br>* figure 4 *<br>----- | 5,6 | |
| Y | US 2019/088335 A1 (HSIUNG CHIA-LIN [US] ET AL) 21 March 2019 (2019-03-21)<br>* paragraph [0096] *<br>* figure 7 *<br>----- | 9,20 | |

TECHNICAL FIELDS SEARCHED (IPC)

H01L
G11C

### INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

1

| Place of search | Date of completion of the search | Examiner |
|---|---|---|
| Munich | 19 October 2022 | Bruckmayer, Manfred |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04E07)

Europäisches Patentamt
European Patent Office
Office européen des brevets

# INCOMPLETE SEARCH SHEET C

Application Number
EP 22 16 0965

**Claim(s) completely searchable:**
1-11, 15-20

**Claim(s) not searched:**
12-14

**Reason for the limitation of the search:**

**Rule 62a EPC**

## ANNEX TO THE EUROPEAN SEARCH REPORT ON EUROPEAN PATENT APPLICATION NO.

EP 22 16 0965

This annex lists the patent family members relating to the patent documents cited in the above-mentioned European search report. The members are as contained in the European Patent Office EDP file on
The European Patent Office is in no way liable for these particulars which are merely given for the purpose of information.

19-10-2022

| Patent document cited in search report | Publication date | Patent family member(s) | Publication date |
|---|---|---|---|
| US 11069410 B1 | 20-07-2021 | US 11069410 B1 | 20-07-2021 |
| | | WO 2022031349 A1 | 10-02-2022 |
| US 10923196 B1 | 16-02-2021 | CN 113223586 A | 06-08-2021 |
| | | DE 102020116365 A1 | 05-08-2021 |
| | | US 10923196 B1 | 16-02-2021 |
| US 2019088335 A1 | 21-03-2019 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 35991919